(19) Europäisches Patentamt / European Patent Office / Office européen des brevets

(11) **EP 2 842 721 B1**

(12) **EUROPEAN PATENT SPECIFICATION**

(45) Date of publication and mention
of the grant of the patent:
**04.01.2017 Bulletin 2017/01**

(21) Application number: **13781178.2**

(22) Date of filing: **19.03.2013**

(51) Int Cl.:
*B29C 59/02* (2006.01)     *B29C 33/38* (2006.01)
*H01L 21/027* (2006.01)     *H01L 51/50* (2006.01)
*H05B 33/02* (2006.01)     *H05B 33/10* (2006.01)
*B29C 45/26* (2006.01)     *B29C 33/42* (2006.01)
*B29K 105/00* (2006.01)     *B29L 11/00* (2006.01)
*B82Y 10/00* (2011.01)     *B82Y 40/00* (2011.01)
*C25D 1/10* (2006.01)     *G03F 7/00* (2006.01)
*G03F 7/16* (2006.01)     *H01L 51/52* (2006.01)

(86) International application number:
**PCT/JP2013/057851**

(87) International publication number:
**WO 2013/161454 (31.10.2013 Gazette 2013/44)**

(54) **METHOD FOR PRODUCING MOLD FOR TRANSFERRING FINE PATTERN, METHOD FOR PRODUCING SUBSTRATE HAVING UNEVEN STRUCTURE USING SAME, AND METHOD FOR PRODUCING ORGANIC EL ELEMENT HAVING SAID SUBSTRATE HAVING UNEVEN STRUCTURE**

VERFAHREN ZUR HERSTELLUNG EINER FORM ZUR ÜBERTRAGUNG EINES FEINEN MUSTERS, VERFAHREN ZUR HERSTELLUNG EINES SUBSTRATS MIT UNEBENER STRUKTUR DAMIT UND VERFAHREN ZUR HERSTELLUNG EINES ORGANISCHEN ELEKTROLUMINESZENTEN ELEMENTS MIT DIESEM SUBSTRAT MIT UNEBENER STRUKTUR

PROCÉDÉ DE PRODUCTION D'UN MOULE POUR TRANSFÉRER UNE STRUCTURE FINE, PROCÉDÉ DE PRODUCTION D'UN SUBSTRAT PRÉSENTANT UNE STRUCTURE IRRÉGULIÈRE EN UTILISANT CELUI-CI ET PROCÉDÉ DE PRODUCTION D'UN ÉLÉMENT ORGANIQUE PRÉSENTANT LEDIT SUBSTRAT PRÉSENTANT UNE STRUCTURE IRRÉGULIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.04.2012 JP 2012101065**

(43) Date of publication of application:
**04.03.2015 Bulletin 2015/10**

(73) Proprietor: **JX Nippon Oil & Energy Corporation Chiyoda-ku Tokyo 100-8162 (JP)**

(72) Inventors:
• **SEKI, Takashi**
  **Tokyo 100-8162 (JP)**
• **MASUYAMA, Satoshi**
  **Tokyo 100-8162 (JP)**
• **FUKUDA, Maki**
  **Tokyo 100-8162 (JP)**
• **NISHIMURA, Suzushi**
  **Tokyo 100-8162 (JP)**

(74) Representative: **Kuhnen & Wacker Patent- und Rechtsanwaltsbüro Prinz-Ludwig-Straße 40A 85354 Freising (DE)**

(56) References cited:
WO-A1-2011/007878     WO-A1-2011/007878
JP-A- 2011 035 233     JP-A- 2011 045 838
JP-A- 2011 243 308     JP-A- 2012 001 787

**(Cont. next page)**

- "Precision Electroforming in High-Strength NiColoy", , 17 May 2011 (2011-05-17), XP055206359, Retrieved from the Internet: URL:https://web.archive.org/web/2011051706 2417/http://www.nicoform.com/files/upload/ upload/105/PrecisionNiCoEfrmg_07.pdf [retrieved on 2015-08-05] & Anonymous: "Internet Archive Wayback Machine", , 17 May 2011 (2011-05-17), XP055206361, Retrieved from the Internet: URL:https://web.archive.org/web/2011050100 0000*/http://www.nicoform.com/files/upload /upload/105/PrecisionNiCoEfrmg_07.pdf [retrieved on 2015-08-05]

- V.K. PARASHAR ET AL: "The Sol-Gel Process for Realisation of Optical Micro-Structures in Glass", KEY ENGINEERING MATERIALS, vol. 264-268, 31 December 2004 (2004-12-31), pages 371-374, XP055206243, DOI: 10.4028/www.scientific.net/KEM.264-268.371

**Description**

TECHNICAL FIELD

The present invention relates to a method for producing a mold for transferring a minute (fine) pattern usable for nano-imprinting, etc., a method for producing a substrate having a concave-convex structure (concavity and convexity structure, uneven or irregular structure) using the mold, a method for producing an organic electro-luminescent (EL) element provided with the substrate having the concave-convex structure, a mold for transferring a fine pattern, a substrate having a concave-convex structure, and an organic EL element which are obtained by using one of the producing methods.

BACKGROUND ART

The lithography method is known as a method for forming a fine pattern such as a semiconductor integrated circuit. The resolution of a pattern formed by the lithography method depends on the wavelength of a light source, the numerical aperture of an optical system, etc., and a shorter wavelength light source is desired so as to respond to the demand for miniaturized devices in the recent years. Any short wavelength light source is, however, expensive and is not easily developed, and any optical material allowing such short wavelength light passing therethrough needs to be developed, as well. Further, a large sized optical element is required for producing a pattern with a large area by means of the conventional lithography method, which is difficult both technically and economically. Therefore, a new method for forming a desired pattern having a large area has been considered.

The nano-imprinting method is known as a method for forming a fine pattern without using any conventional lithography apparatus. The nano-imprinting method is a technique capable of transferring a pattern in nano-meter order by sandwiching a resin between a mold and a substrate, and basically is composed of the following four steps of: (i) coating with a resin layer (application of a resin layer), (ii) pressing with the mold, (iii) transferring of the pattern and (iv) releasing of the mold (mold-releasing). Thus, the nano-imprint method is excellent in that the nano-sized processing can be realized with such a simple process. Further, in the nano-imprint method, devises or apparatuses used therefor are simple, the processing can be performed for a large area as well as a high throughput can be expected. Accordingly, the nano-imprint method is expected to be practiced not only in the field of semiconductor device but also in many fields such as storage media, optical members, biochips, etc.

In the nano-imprint method as described above, however, a mold for transferring a pattern having a line width of several tens of nanometers (nm) needs to be formed basically by exposing a resist on a silicon substrate and developing the resist to form a resist pattern (a pattern of a resist), with a lithography apparatus. Further, an electric current seed layer (current seed layer) made of a metal is formed on the resist pattern for performing electroforming (electroplating) of the mold by using the obtained resist pattern. However, in a case that the pattern fineness is not more than 100 nm, the coating performance (coatability or coverage) of the current seed layer formed on the pattern by sputtering is lowered, which in turn causes such a state that the film thickness (thickness) of the obtained current seed layer is different or non-uniform among an upper portion, a side wall portion and a bottom portion of the resist pattern (the bottom portion being a substrate-exposure portion in which the substrate is exposed in a recessed portion in the pattern, namely in a trench). In particular, the formation of the current seed layer is progressed preferentially in the upper portion of the resist pattern, thereby causing such a problem that the opening of the trench is constricted or narrowed. Consequently, in a case that holes or trenches and ridges are formed on the substrate by using the resist layer, there is such a problem that the metal of the current seed layer is hardly deposited in the bottom portions of the holes or trenches, and that any overhang is generated at the upper portions of the ridges of the resist layer. When any stacked body with such a current seed layer is subjected to the electroforming, an electroplating film is joined at a portion above the hole or trench due to the overhang, leaving a void inside the trench. As a result, a mold obtained by the electroforming has low mechanical strength, which in turn causes such a problem including defect exemplified by any deformation of the mold, deficit (chipped) pattern, etc.

In order to solve the above problem, Patent Literature 1 discloses a method for producing a mold for nano-imprint including the steps of:

forming a resist layer having a concave-convex pattern, which is composed of concave portions and convex portions (concavities and convexities), on a substrate having a conductive surface and causing the conductive surface to be exposed at the concave portions of the concave-convex pattern of the resist layer;

performing electroforming on the conductive surface exposed at the concave portions of the concave-convex pattern of the resist layer to form a electroforming film having a thickness greater than a thickness of the resist layer; and

removing the substrate having the conductive surface and the resist layer.

Since this method is capable of growing the electroforming film in unidirectional manner upwardly from the conductive surface at the bottom portion of the resist pattern without using a current seed layer, it is considered that any void is not present inside the mold for nano-imprint. Even with this method, however, the mold used in the nano-imprint method should be made with the lithography method, same as before.

[CITATION LIST]

[PATENT LITERATURE]

PATENT LITERATURE 1: Japanese Patent Application Laid-open No. 2010-017865
PATENT LITERATURE 2: PCT International Publication No. WO2011/007878A1
PATENT LITERATURE 3: Japanese Patent Application Laid-open No. 2010-056256

SUMMARY OF INVENTION

Problem to be Solved by the Invention:

The inventors of the present invention disclose the following method in PATENT LITERATURE 2. Namely, a block copolymer solution containing a block copolymer satisfying a predetermined condition and a solvent is applied on a base member (the base member is coated with the block copolymer solution), and drying is performed for the applied block copolymer solution to form a micro phase separation structure of the block copolymer, thereby obtaining a master block (mold) in which a fine (minute) and irregular concave-convex pattern is formed. According to this method, it is possible to obtain the master block usable for the nano-imprint and the like by using a self-organizing phenomenon of the block copolymer, without using the lithography method. A mixture of a silicone-based polymer and a curing agent is dropped onto the obtained master block and then cured to obtain a transferred pattern. Then, a glass substrate coated with a curable resin is pressed to (against) the transferred pattern and the curable resin is cured by irradiation with an ultraviolet light. In this way, a diffraction grating in which the transferred pattern is duplicated is manufactured. It has been confirmed that an organic EL diode (organic light-emitting diode) obtained by stacking a transparent electrode, an organic layer, and a metal electrode on the diffraction grating has sufficiently high light emission efficiency, sufficiently high level of external extraction efficiency, as well as sufficiently low wavelength-dependence of light emission, sufficiently low directivity of light emission, and sufficiently high power efficiency.

In this method, however, a step is required for removing one of polymers composing the block copolymer with the etching process, so as to obtain the concave-convex pattern after the formation of the micro phase separation structure of the block copolymer. Due to this removing step, one of the polymers is removed as portions at each of which the base member is exposed and the other of the polymers is remained to form the convex portions. However, the remaining convex portions have small area of contact with the surface of the base member, and thus easily drop off or detach from the surface of the base member. Further, there is a case that any foreign matter adheres to the base member and/or the surfaces of the convex portions accompanying with the etching process, which in turn presents a possibility that the master block or a diffraction grating produced from the master block via a transfer process might be contaminated. If these cases happened in a mass production process of diffraction gratings, there is a fear that the throughput might be lowered in the mass production process of diffraction gratings or of organic EL elements produced by using the diffraction gratings. Therefore, there is a demand to further advance the method for producing the diffraction grating achievable in the preceding patent application by the inventors of the present invention (Patent Literature 2), for the purpose of providing a production method further suitable for mass production of products such as organic EL elements, etc.

Patent Literature 3 disclose forming a columnar-shaped micro domain structure, lamella-type micro domain structure, etc., by phase-separating a high polymer layer including a block copolymer of which molecular weight is relatively low. This method, however, removes one of the polymers by the etching, etc., for the patterning purpose.

In view of the above situation, an object of the present invention is to provide a method for producing a mold for transferring a fine pattern suitable for mass-producing a substrate having a concave-convex structure such as a diffraction grating usable for a general-purpose item such as an organic EL element, a method for producing a substrate having a concave-convex structure by using the obtained mold, and a method for producing an organic EL element using the substrate having such concave-convex structure. Another object of the present invention is to produce a mold for transferring a fine pattern, a substrate having a concave-convex structure, and an organic EL element with a high throughput by using one of these producing methods.

Solution to the Problem:

According to the present invention, there is provided a method for producing a mold for transferring a fine pattern, the method including:

a step of coating a surface of a base member with a solution containing a block copolymer and polyalkylene oxide, the block copolymer being composed of at least first and second polymer segments;
a solvent phase-separation step of phase-separating the block copolymer contained in the solution, with which the surface of the base member is coated, under a presence of vapor of an organic solvent so as to obtain a block copolymer film of the block copolymer, the block copolymer film having a concave-convex structure on a surface thereof and a horizontal cylinder structure in an interior thereof;
a step of forming a seed layer on the concave-convex structure of the block copolymer film;
a step of stacking a metal layer on the seed layer by electroforming; and
a step of releasing the base member, on which the concave-convex structure is formed, from the metal layer, wherein a volume ratio between the first and second polymer segments in the block copolymer is in a range of 4:6 to 6:4.

In the method for producing the mold of the present invention, a volume ratio between the first and second polymer segments in the block copolymer is in a range of 4:6 to 6:4, in view of generating the horizontal cylinder structure. Further, a content amount of the polyalkylene oxide is preferably in a range of 5 parts by mass to 70 parts by mass relative to 100 parts by mass of the block copolymer, in view of obtaining sufficient height (groove depth) of the concave-convex structure. Furthermore, number average molecular weight of the block copolymer is preferably not less than 500,000. Since a wave-like (wave-like shaped) concave-convex structure can be obtained by the solvent phase-separation step in the producing method of the present invention, any etching process is not necessary after the solvent phase-separation process (step).

In the method for producing the mold of the present invention, the first polymer segment composing the block copolymer may be polystyrene; the second polymer segment composing the block copolymer may be polymethyl methacrylate. Further, the organic solvent may be one selected from the group consisting of chloroform, acetone, dichloromethane, and a mixed solvent of carbon bisulfide and acetone. Further, a time for phase-separating the block copolymer under the presence of the vapor of the organic solvent may be in a range of 6 hours to 168 hours.

In the method for producing the mold of the present invention, even in a case that the first or second polymer segment is formed to have a one-tiered (one-stage) structure or a two-tiered (two-stage) structure in the horizontal cylinder structure, the concave-convex structure appears on the surface. As the mold for the substrate having the concave-convex structure such as a diffraction grating, it is desirable that an average value of depth distribution of concavities and convexities of the concave-convex structure is in a range of 20 nm to 200 nm, preferably in a range of 30 nm to 150 nm; and that standard deviation of depth of the concavities and convexities is in a range of 10 nm to 100 nm, more preferably in a range of 15 nm to 75 nm.

In the method for producing the mold of the present invention, it is preferable that a primer layer is formed on the surface of the base member before coating the surface of the base member with the solution containing the block copolymer, which is composed of at least the first and second polymer segments, and the polyalkylene oxide. Further, molecular weight distribution (Mw/Mn) of the block copolymer is preferably not more than 1.5, and difference in solubility parameter between the first and second polymer segments is in a range of 0.1 $(cal/cm^3)^{1/2}$ to 10 $(cal/cm^3)^{1/2}$.

According to a second aspect of the present invention, there is provided a method for producing a diffraction grating, the method including:

pressing a mold obtained by the above method for producing the mold onto (against) a substrate coated with a concavity-convexity forming material and curing the concavity-convexity forming material, and removing the mold from the substrate so as to form a diffraction grating having a concave-convex structure on the substrate.

According to a third aspect of the present invention, there is provided a method for producing a diffraction grating, the method including:

pressing a mold obtained by the above method for producing the mold onto a substrate coated with a concavity-convexity forming material, curing the concavity-convexity forming material, and removing the mold from the substrate so as to form a structure having a concave-convex structure on the substrate; and
pressing the structure onto another substrate coated with a sol-gel material, curing the sol-gel material, and removing the structure from the another substrate so as to form a diffraction grating having a concave-convex structure formed of the sol-gel material.

According to a fourth aspect of the present invention, there is provided a method for producing an organic EL element, the method including: stacking a transparent electrode, an organic layer and a metal electrode successively on a concave-convex structure of a diffraction grating, produced by the above method of producing the diffraction grating, so as to form the organic EL element.

According to a fifth aspect of the present invention, there is provided a mold for transferring a fine pattern produced by the above method for producing the mold.

According to a seventh aspect of the present invention, there is provided a method for producing an organic EL element.

According to an eighth aspect of the present invention, there is provided a method for producing a substrate having a concave-convex structure, the method including: pressing a mold obtained by the above method for producing the mold onto a substrate coated with a concavity-convexity forming material, curing the concavity-convexity forming material, and removing the mold from the substrate so as to form the substrate having a concave-convex structure.

According to a ninth aspect of the present invention, there is provided a method for producing a substrate having a concave-convex structure, the method including:

pressing the structure onto another substrate coated with a sol-gel material, curing the sol-gel material, and removing the structure from the another substrate so as to form the a substrate having a concave-convex structure formed of the sol-gel material.

Effects of Invention:

According to the method for producing the mold of the present invention, a block copolymer film of which surface has a smooth and wave-like concave-convex structure and of which cross-sectional structure has a horizontal cylinder structure can be obtained by phase-separating the solution, which contains the block copolymer, with the organic solvent so as to cause the self-organization of the block copolymer. Thus, the etching step which has been required for forming the concave-convex structure becomes unnecessary, thereby realizing a simplified production process and lowering the possibility that any dirt (stain, soil, dust) and/or any foreign matter might adhere to the mold through the production process, as well. The surface property of a metal layer of the obtained mold is such that smooth concavities and convexities are distributed substantially uniformly, and that a resin is suppressed from remaining on a side of the mold when the block copolymer and the base member are released (peeled off) from the mold, thereby enhancing the releasing property (peeling property) of the mold. With this, any pattern defect is prevented from generating. Further, even in a case that the molecular weight of the block copolymer is as high as 500,000 or more, it is possible to form a mold having a desired concave-convex pattern in an ensured manner. Therefore, by using a mold obtained by the present invention, a substrate having the concave-convex structure, such as a diffraction grating diffracting a light of the visible region without any wavelength dependency and with low directivity, can be produced with a relatively low cost and with a high throughput.

BRIEF DESCRIPTION OF DRAWINGS

Fig. 1(A) to 1(F) is a view conceptually showing the steps in a mold-producing method of the present invention.
Fig. 2(A) to 2(E) is a view conceptually showing the steps for producing a diffraction grating using a mold obtained by the mold-producing method of the present invention.
Fig. 3 is a flowchart showing the steps in the mold-producing method of the present invention.
Fig. 4 is a conceptual view of a roll processing apparatus for producing a film-shaped substrate as a mold to be used in a diffraction-grating producing method.
Fig. 5 is a flowchart showing steps for producing a concave-convex substrate, which has concavities and convexities made of a sol-gel material, by using the film-shaped substrate as the mold.
Fig. 6 is a conceptual view for explaining a roll processing for performing transfer on the sol-gel material by using the film-shaped substrate as the mold.
Fig. 7 is a conceptual view showing a stacked structure of an organic EL element by using a diffraction grating obtained by the diffraction-grating producing method of the present invention.
Fig. 8A is a photograph of the cross section of a thin film, obtained by Example 1, after solvent annealing observed by a transmission electron microscope, showing a two-tiered (two-stage) horizontal cylinder structure.
Fig. 8B is an enlarged photograph of the photograph of Fig. 8A.
Fig. 8C is a photograph of the cross section of the thin film, obtained by Example 1 after solvent annealing, observed by the transmission electron microscope, showing a one-tiered (one-stage) horizontal cylinder structure.
Fig. 8D is an enlarged photograph of the photograph of Fig. 8C.

Fig. 9A is a photograph showing a concavity and convexity analysis image, taken by an atomic force microscope, of a surface of a concave-convex structure of the thin film obtained in Example 1.

Fig. 9B is a photograph showing a concavity and convexity analysis image, taken by the atomic force microscope, of the cross section at a portion in the vicinity of the surface of the concave-convex structure of the thin film shown in Fig. 9A.

Fig. 9C is a photograph showing a Fourier-transformed image obtained based on the concavity and convexity analysis images shown in Figs. 9A and 9B.

Fig. 10A is a photograph showing a concavity and convexity analysis image, taken by an atomic force microscope, of a surface of a concave-convex structure of a thin film obtained in Comparative Example 1.

Fig. 10B is a photograph showing a concavity and convexity analysis image, taken by the atomic force microscope, of the cross section at a portion in the vicinity of the surface of the concave-convex structure of the thin film shown in Fig. 10A.

Fig. 10C is a photograph showing a Fourier-transformed image obtained based on the concavity and convexity analysis images shown in Figs. 10A and 10B.

Fig. 11 is a graph showing the change in electric current efficiency with respect to the luminance (brightness) of an organic EL element produced in Example 7.

Fig. 12 is a graph showing the change in electric power efficiency with respect to the luminance of the organic EL element produced in Example 7.

## DESCRIPTION OF EMBODIMENTS

In the following, a preferred embodiment of the present invention will be described in detail with reference to the drawings.

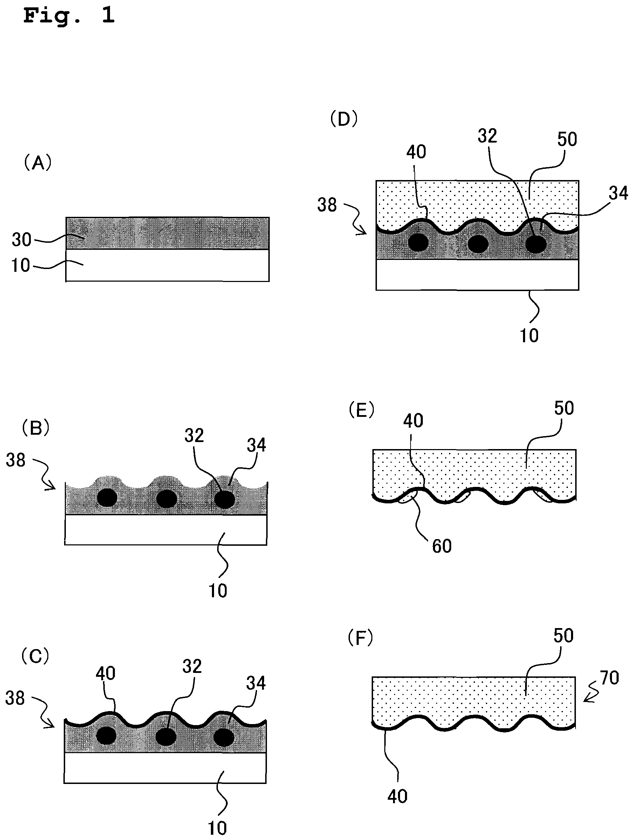

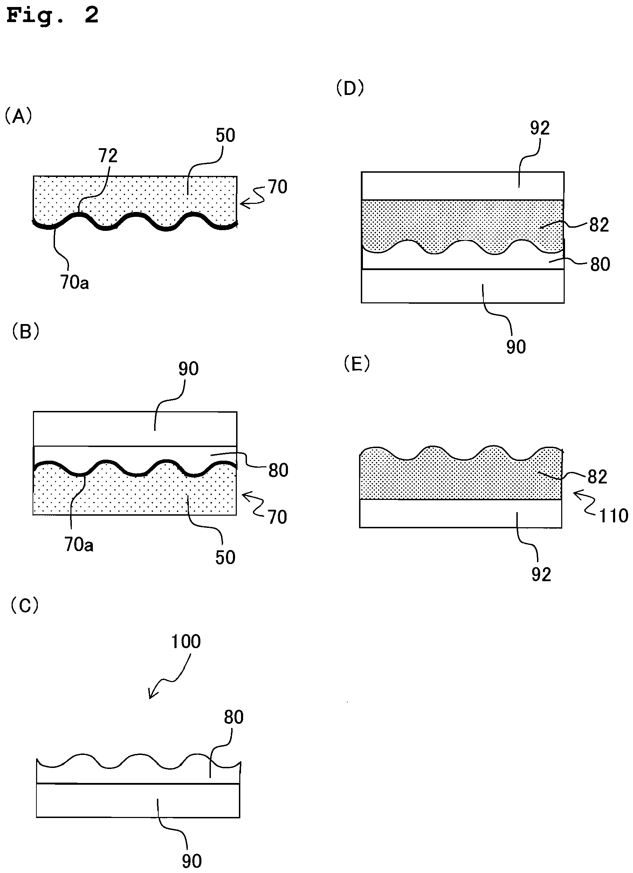

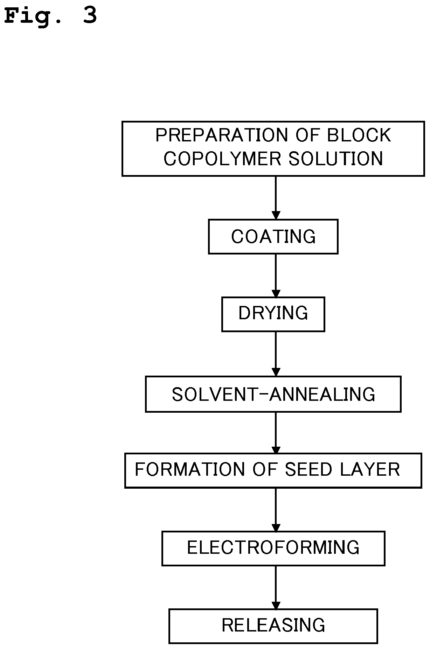

At first, an explanation will be given about a mold-producing method for producing a mold suitable for producing a substrate having a concave-convex structure such as a diffraction grating usable for an organic EL element. As shown in a flowchart of Fig. 3, the mold-producing method mainly includes a step for preparing a solution of block copolymer (block copolymer solution), a step of coating a base member with the block copolymer solution (applying the block copolymer solution), a drying step, a solvent annealing step, a step of forming a seed layer, an electroforming step and a releasing step (peeling step). In the following, an explanation will be given about the respective steps of the mold-producing method and steps following the mold-producing method, also referring to the conceptual views shown in Figs. 1 and 2. Note that although the following explanation is given about a diffraction grating substrate as an example of a substrate having concave-convex structure, a substrate having the concave-convex structure according to the present invention is not limited to the optical substrate such as the diffraction grating substrate and is applicable also to a variety of substrates having various applications, as will be described later on.

[Preparation step of block copolymer solution]

The block copolymer used for present invention includes at least a first polymer segment made of a first homopolymer and a second polymer segment made of a second homopolymer different from the fist homopolymer. The second homopolymer desirably has a solubility parameter which is higher than a solubility parameter of the first homopolymer by 0.1 $(cal/cm^3)^{1/2}$ to 10 $(cal/cm^3)^{1/2}$. In a case that the difference in the solubility parameter between the first and second homopolymers is less than 0.1 $(cal/cm^3)^{1/2}$, it is difficult to form a regular micro phase separation structure of the block copolymer. In a case that the difference exceeds 10 $(cal/cm^3)^{1/2}$, it is difficult to prepare a uniform solution of the block copolymer.

Examples of monomers serving as raw materials of homopolymers usable as the first homopolymer and second homopolymer include styrene, methylstyrene, propylstyrene, butylstyrene, hexylstyrene, octylstyrene, methoxystyrene, ethylene, propylene, butene, hexene, acrylonitrile, acrylamide, methyl methacrylate, ethyl methacrylate, propyl methacrylate, butyl methacrylate, hexyl methacrylate, octyl methacrylate, methyl acrylate, ethyl acrylate, propyl acrylate, butyl acrylate, hexyl acrylate, octyl acrylate, methacrylic acid, acrylic acid, hydroxyethyl methacrylate, hydroxyethyl acrylate, ethylene oxide, propylene oxide, dimethylsiloxane, lactic acid, vinylpyridine, hydroxystyrene, styrenesulfonate, isoprene, butadiene, ε-caprolactone, isopropylacrylamide, vinyl chloride, ethylene terephthalate, tetrafluoroethylene, and vinyl alcohol. Among these monomers, styrene, methyl methacrylate, ethylene oxide, butadiene, isoprene, vinylpyridine, and lactic acid are preferably used from the viewpoints that the formation of phase separation easily occurs, and that concavities and convexities of the concave-convex structure are easily formed by an etching.

Further, examples of a combination of the first homopolymer and the second homopolymer may include combinations of two selected from the group consisting of a styrene-based polymer (more preferably, polystyrene), polyalkyl methacrylate (more preferably, polymethyl methacrylate), polyethylene oxide, polybutadiene, polyisoprene, polyvinylpyridine, and polylactic acid. Among these combinations, a combination of the styrene-based polymer and polyalkyl methacrylate, a combination of the styrene-based polymer and polyethylene oxide, a combination of the styrene-based polymer and polyisoprene, a combination of the styrene-based polymer and polybutadiene are more preferable, and the combination of the styrene-based polymer and polymethyl methacrylate, the combination of the styrene-based polymer and polyisoprene, the combination of the styrene-based polymer and polybutadiene are particularly preferable. A combination of polystyrene (PS) and polymethyl methacrylate (PMMA) is further preferable from the viewpoint of obtaining a preferable number average molecular weight (Mn) of the block copolymer.

The number average molecular weight (Mn) of the block copolymer is preferably not less than 500,000, and more preferably not less than 1,000,000, and particularly preferably in a range of 1,000,000 to 5,000,000. The domain size of the block copolymer increases as the molecular weight thereof increases. In a case that the number average molecular weight is less than 500,000, the average pitch of the concavities and convexities formed by the micro phase separation structure of the block copolymer is so small that the average pitch of the concavities and convexities of the obtained diffraction grating becomes insufficient. Especially, in a case of the diffraction grating used for the organic EL, the diffraction grating needs to diffract illumination light over a range of wavelength of the visible region, and thus the average pitch is desirably in a range of 100 nm to 1,500 nm, more desirably in a range of 200 nm to 1,200 nm. In view of this point, the number average molecular weight (Mn) of the block copolymer is preferably not less than 500,000.

The molecular weight distribution (Mw/Mn) of the block copolymer is preferably not more than 1.5, and is more preferably in a range of 1.0 to 1.35. In a case that the molecular weight distribution exceeds 1.5, it is difficult to form the regular micro phase separation structure of the block copolymer.

Note that the number average molecular weight (Mn) and the weight average molecular weight (Mw) of the block copolymer are values measured by the gel permeation chromatography (GPC) and converted to the molecular weights of standard polystyrene.

In the block copolymer, the volume ratio between the first polymer segment and the second polymer segment (the first polymer segment: the second polymer segment) is in a range of 4:6 to 6:4 in order to generate a horizontal cylinder structure by self-organization or assembly (to be described later on), and is preferably about 5:5. In a case that the volume ratio is out of the above-described range, it is difficult to form a concave-convex pattern (concavity and convexity pattern) owing to the horizontal cylinder structure (to be described later on) and there is a tendency that a globular or spherical structure or vertical cylinder structure appears.

The block copolymer solution used in the present invention is prepared by dissolving the block copolymer in a solvent. Examples of the solvent include aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycol ethers such as ethylene glycol dimethyl ether, diethylene glycol dimethyl ether, triglyme, propylene glycol monomethyl ether, and propylene glycol monomethyl ether acetate; esters such as ethyl acetate, ethyl lactate, and $\gamma$-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; and mixture solvents thereof. The percentage content of the block copolymer in the block copolymer solution is preferably in a range of 0.1% by mass to 15% by mass, and more preferably in a range of 0.3% by mass to 5% by mass, relative to 100% by mass of the block copolymer solution.

In addition, the block copolymer solution further contains polyalkylene oxide as a different homopolymer (a homopolymer other than the first homopolymer and the second homopolymer in the block copolymer contained in the solution: for example, in a case that the combination of the first homopolymer and the second homopolymer in the block copolymer is the combination of polystyrene and polymethyl methacrylate, the different homopolymer may be any kind of homopolymer other than polystyrene and polymethyl methacrylate).

By allowing the block copolymer solution to contain polyalkylene oxide, the depth of the concavities and convexities formed by the micro phase separation structure of the block copolymer can be increased. As the polyalkylene oxide, polyethylene oxide or polypropylene oxide is more preferable, and polyethylene oxide is particularly preferable. Further, as the polyethylene oxide, one represented by the following formula is preferable:

$$HO\text{-}(CH_2\text{-}CH_2\text{-}O)_n\text{-}H$$

[in the formula, "n" represents an integer in a range of 10 to 5,000 (more preferably an integer in a range of 50 to 1,000, and further preferably an integer in a range of 50 to 500)].

Further, the number average molecular weight (Mn) of polyalkylene oxide is preferably in a range of 460 to 220,000, and is more preferably in a range of 2,200 to 46,000. In a case that the number average molecular weight is less than the lower limit, the molecular weight is so low that polyalkylene oxide is liquid at room temperature, is easily separated out and precipitates; in another case that the number average molecular weight exceeds the upper limit, the synthesis of such polyalkylene oxide is difficult.

The molecular weight distribution (Mw/Mn) of polyalkylene oxide is preferably not more than 1.5, and more preferably in a range of 1.0 to 1.3. In a case that the molecular weight distribution exceeds the upper limit, the uniformity of shape of the micro phase separation is less likely to be maintained. Note that the number average molecular weight (Mn) and the weight average molecular weight (Mw) are values measured by the gel permeation chromatography (GPC) and converted to molecular weights of standard polystyrene.

Further, in the present invention, it is preferable that the combination of the first homopolymer and the second homopolymer in the block copolymer is the combination of polystyrene and polymethyl methacrylate (polystyrene-polymethyl methacrylate). By using a polystyrene-polymethyl methacrylate block copolymer and polyalkylene oxide such as polyethylene oxide in combination as described above, the orientation in the vertical direction is further improved, thereby making it possible to further increase the depths of the concavities and convexities on the surface, and to shorten the solvent annealing process time during the production.

The content of polyalkylene oxide is preferably in a range of 1 part by mass to 100 parts by mass, and particularly preferably in a range of 5 parts by mass to 100 parts by mass, relative to 100 parts by mass of the block copolymer. The content of polyalkylene oxide is further preferably in a range of 5 parts by mass to 70 parts by mass. In a case that the content of polyalkylene oxide is less than 5 parts by mass, the effect obtained by containing polyalkylene oxide becomes insufficient. On the other hand, in a case that the content of polyalkylene oxide exceeds 100 parts by mass relative to 100 parts by mass of the block copolymer, the concave-convex pattern formed by the phase separation of the block copolymer easily collapses; in a case that the content of polyalkylene oxide exceeds 70 parts by mass, polyalkylene oxide precipitates in some cases.

The total percentage content of polyalkylene oxide and the different homopolymer in the block copolymer solution is preferably in a range of 0.1 % by mass to 15% by mass, and more preferably in a range of 0.3% by mass to 5% by mass, in the block copolymer solution. In a case that the total percentage content is less than the lower limit, it is difficult to uniformly apply the solution on a base member (coat a base member with the solution) to attain a film of which thickness is sufficient to obtain a necessary film thickness. On the other hand, in a case that the total percentage content exceeds the upper limit, it is relatively difficult to prepare a solution in which polyalkylene oxide and the different homopolymer are uniformly dissolved in the solvent.

Further, the block copolymer solution may further contain another homopolymer different from polyalkylene oxide, a surfactant, an ionic compound, an anti-foaming agent, a leveling agent, and the like.

In a case that the block copolymer solution contains the another homopolymer, the another homopolymer may be contained at a ratio in a range of 1 part by mass to 100 parts by mass, relative to 100 parts by mass of the block copolymer, similarly to polyalkylene oxide. In a case that the surfactant is used, the content of the surfactant is preferably not more than 10 parts by mass, relative to 100 parts by mass of the block copolymer. Further, in a case that the ionic compound is used, the content of the ionic compound is preferably not more than 10 parts by mass, relative to 100 parts by mass of the block copolymer.

[Block copolymer solution coating step]

According to the mold-producing method of the present invention, as shown in Fig. 1(A), the block copolymer solution prepared as described above is applied on a base member 10 (a base member 10 is coated with the block copolymer solution) to form a thin film 30. The base member 10 is not especially limited, and includes, for example, resin substrates of resins such as polyimide, polyphenylene sulfide (PPS), polyphenylene oxide, polyether ketone, polyethylene naphthalate, polyethylene terephthalate, polyarylate, triacetyl cellulose, and polycycloolefin; inorganic substrates such as glass, octadecyldimethyl chlorosilane (ODS) treated glass, octadecyl trichlorosilane (OTS) treated glass, organo silicate treated glass, glass substrates treated with a silane coupling agent, and silicon substrates; and substrates of metals such as aluminum, iron, and copper. Further, the base member 10 may be subjected to a surface treatment such as an orientation treatment, etc. For example, the organo silicate treated glass can be prepared by coating a glass with a methyl isobutyl ketone (MIBK) solution of methyl trimethoxysilane (MTMS) and 1,2-bis(trimethoxysilyl) ethane (BTMSE), and then performing heating process to the glass coated with the MIBK solution. Further, each of the octadecyldimethyl chlorosilane treated glass and octadecyl trichlorosilane treated glass can be prepared by such a method including immersing a glass in a heptane solution of one of the octadecyldimethyl chlorosilane and octadecyl trichlorosilane, and washing out the unreacted portion from the glass. In such a manner, it is allowable to perform surface treatment to a surface of the substrate such as the glass with a primer layer of the octadecyldimethyl chlorosilane, organo silicate, etc., or to perform the silane coupling treatment to the substrate surface with a general silane coupling agent, thereby making it possible to improve the adhesion property of the block copolymer to the substrate. In a case that the adhesion property is not sufficient, the block copolymer drops off or detaches from the substrate during the electroforming, which in turn adversely affect the production of a mold for transferring.

The method for applying the block copolymer solution on the base member (coating the base member with the block copolymer) is not particularly limited; it is allowable to employ, for example, the spin coating method, spray coating method, dip coating method, dropping method, gravure printing method, screen printing method, relief printing method, die coating method, curtain coating method, ink-jet method, etc., as the method for applying the block copolymer solution.

The thickness of the thin film 30 of the block copolymer is preferably within a range which allows the thickness of a dried coating film, as will be described later, to be in a range of 10 nm to 3,000 nm, and more preferably within a range which allows the thickness of the dried coating film to be in a range of 50 nm to 500 nm.

[Drying step]

After the base member 10 is coated with the block copolymer solution to form the thin film 30, the thin film 30 on the base member 10 is dried. The drying can be performed in the ambient atmosphere. The temperature for drying the thin film 30 is not particularly limited, provided that the solvent can be removed from the thin film 30. For example, the drying temperature is preferably in a range of 10 degrees Celsius to 200 degrees Celsius, and more preferably in a range of 20 degrees Celsius to 100 degrees Celsius. Note that in some cases, the drying step starts the formation of micro phase separation structure of the block copolymer, which results in appearance of concavities and convexities on the surface of the thin film 30 during the drying step.

[Solvent annealing step]

After the drying step, the solvent annealing process (solvent phase-separation process) is performed for the thin film 30 under atmosphere of the vapor of an organic solvent so as to form a phase separation structure of the block copolymer inside the thin film 30. With this solvent annealing process, the self-organization of the block copolymer is advanced such that the block copolymer undergoes micro phase separation into a portion corresponding to a first polymer segment 32 and a portion corresponding to a second polymer segment 34, thereby generating a horizontal cylinder structure, as shown in Fig. 1(B). Here, the term "horizontal cylinder structure" means a structure wherein the first polymer segment or the second polymer segment is self-organized such that the first or second polymer segment extends (is oriented) in a form of cylinders in a direction along the surface, of the base member, coated with the solution of the block copolymer. On the other hand, the term "vertical cylinder structure" means a structure wherein the first polymer segment or the second polymer segment is self-organized such that the first or second polymer segment extends (is oriented) in a form of cylinders in a direction substantially vertical to the surface, of the base member, coated with the solution of the block copolymer. These structures can be confirmed by staining the polymer with ruthenium oxide or osmium oxide and by observing the cross-sectional shape of the stained polymer with an electron microscope, etc. In addition, the small-angle X-ray scattering (SAXS) measurement is also effective for identifying the orientation of these structures.

For example, the solvent annealing process can be practiced by providing atmosphere of the vapor of organic solvent (organic solvent vapor) inside a tightly sealable container such as a desiccator, and by exposing the thin film 30 as the objective under this atmosphere. The concentration of the organic solvent vapor is preferably high for the purpose of promoting the phase separation of the block copolymer, is preferably saturated vapor pressure. In a case that the concentration of the organic solvent vapor is saturated vapor pressure, the concentration of the organic solvent vapor is relatively easy to control. For example, in a case that the organic solvent is chloroform, the saturated vapor pressure of chloroform is known to be in a range of 0.4 g/l to 2.5 g/l at room temperature (0 degrees Celsius to 45 degrees Celsius). In a case that the organic solvent annealing process time using the organic solvent such as chloroform is too long, the polyethylene oxide tends to precipitate on the surface of the applied (coating) film and/or the phase-separated concave-convex shape (pattern) tends to collapse (to become blunt). The process time (process time period) of the solvent annealing process can be in a range of 6 hours to 168 hours, preferably in a range of 12 hours to 48 hours, more preferably in a range of 12 hours to 36 hours. In a case that the process time is too long, the concave-convex shape collapses (becomes blunt); in a case that the process time is too short, the depth of the grooves in the concave-convex structure is shallow, and in a case that a diffraction grating is produced by using the mold, the diffraction effect of the diffraction grating is not sufficient.

The organic solvent to be used in the solvent annealing process is preferably an organic solvent of which boiling point is in a range of 20 degrees Celsius to 120 degrees Celsius; it is possible to use, for example, chloroform, dichloromethane, toluene, tetrahydrofuran (THF), acetone, carbon disulfide, and mixture solvents thereof. Among these solvents, chloroform, dichloromethane, acetone, a mixture solvent of acetone/carbon disulfide are preferable. The solvent annealing may be performed at the ambient temperature in a range of 0 degrees Celsius to 45 degrees Celsius. In a case that the ambient temperature is higher than 45 degrees Celsius, the concave-convex structure formed in the thin film become blunt and easily collapses. In an environment lower than 0 degrees Celsius, the organic solvent hardly evaporates, and the phase separation of the block copolymer is hard to occur.

The inventors of the present invention found out that the solvent annealing process causes the block copolymer to undergo the phase separation into the horizontal cylinder structure. Normally, the following is known: in a case that the mixing ratio between the first homopolymer and the second homopolymer constructing the block copolymer is even (5:5) or approximately even, a phase separation structure of the lamella type appears by the thermal annealing process; in a case that the mixing ratio is approximately 3:7, the cylinder structure appears by the thermal annealing process; and in a case that the mixing ratio is approximately 2:8, the spherical structure appears by the thermal annealing process. However, the inventors found out that, when performing the solvent annealing process according to the present invention, the phase separation occurs while generating a cylinder structure in the horizontal direction even in a case that the mixing ratio of the first homopolymer and the second homopolymer constructing the block copolymer is in a range of 40:60 to 60:40. Although the reason for the above phenomenon is not clear, the inventors consider that as the organic solvent permeates into one of the homopolymers and causes one of the homopolymers to swell, which in turn creates such a situation that the apparent volume ratio between the first and second homopolymers is different from the actual mixing ratio between the first and second homopolymers.

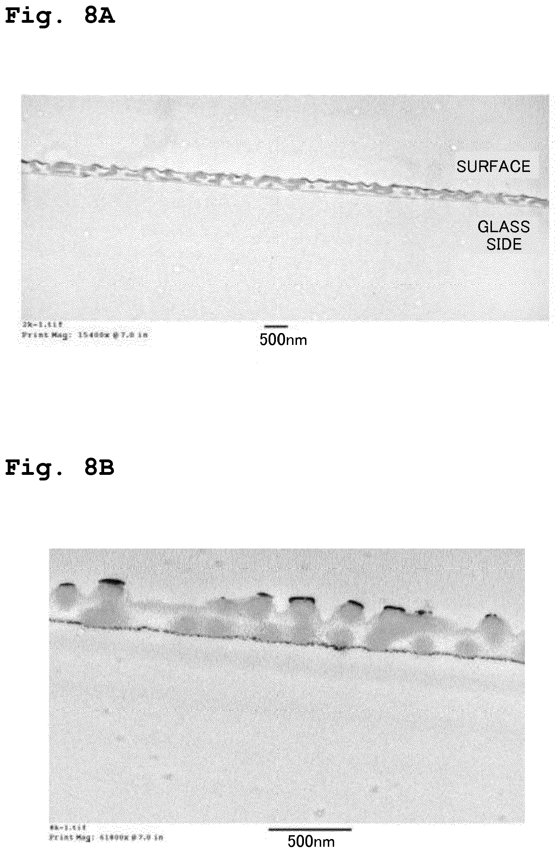

In the horizontal cylinder structure, a first homopolymer 32 is present in a layer of a second homopolymer 34, and is oriented in a form of cylinders extending in a direction substantially parallel to the surface of the base member 10, as shown in Fig. 1(B). As a result, a surface (top) layer portion, of the second homopolymer 34, under (inside) which the first homopolymer 32 is present, is smoothly raised to form a wave-like shape. Note that it is allowable that the cylinder-like arrangement in which the first homopolymer 32 is oriented in the form of cylinders extending in the direction substantially parallel to the surface of the base member 10 is formed in a plurality of layers (plurality of tiers or stages) in a direction (height direction) vertical to the surface of the base member 10 (see Figs. 8A and 8B which will be described later on). The raised wave-like structure can be used as it is as a concave-convex pattern of an optical substrate such as a diffraction grating. Accordingly, unlike the case of phase separation by the thermal annealing, there is no need to remove one of the homopolymers by the etching after the phase separation. Note that a vertical cylinder structure or a spherical structure may be included in a part of the horizontal cylinder structure.

Since the etching process is not necessary in the solvent annealing process, the patterning process for the mold can be simplified. Further, although the etching process normally involves the following problems, the mold-producing method of the present invention does not involve such problems. Namely, when performing the etching process, any projecting portion is easily generated in the remaining homopolymer pattern, the value of kurtosis (to be described later on) is small, and any cross-sectional shape having an overhang portion is easily generated. Accordingly, in the electroforming process performed thereafter, the plating metal is easily drawn to a projection portion and/or a projected corner (edge) of the object, and is less likely to be drawn to a recessed portion or a dented portion of the object. Further, a seed layer to be deposited before the electroplating process is also less likely to adhere to a portion having such a complicated structure. Due to the situations described above, any defect is likely to occur in the pattern due to the etching process. Furthermore, any stain and/or debris (dust) are/is easily generated on the mold in the etching process due to the usage of etching liquid and/or the removal of one of the homopolymers constructing the block copolymers. By using the solvent annealing process, however, the necessity for the etching process is eliminated, thereby solving the above-described problems associated with the etching and making it possible to obtain a mold which has a reliable concave-convex pattern and to which little foreign matter adheres and to obtain an optical substrate such as a diffraction grating produced based on the mold. Accordingly, the optical substrate such as the diffraction grating can be produced with a high throughput and in a simple process.

In the present invention, the surface shape defined by the polymer segment 34 through the solvent annealing process is constructed of a relatively smooth and sloped (inclined) surface, as conceptually shown in Fig. 1 (B), forming a wave-like shape (referred to as "wave-like structure" in the present application, as appropriate) in a direction upward from the base member. In such a wave-like structure 38, there is no overhang, and thus the wave-like structure is duplicated into an inverted pattern in a metal layer accumulated on the wave-like structure 38, thereby allowing the metal layer to be easily releasable (peelable).

The base member 10, which has the wave-like structure 38 obtained in such a manner, can be used as a master (mold) for transfer in a subsequent step. The average pitch of the concavities and convexities representing the wave-like structure 38 is preferably in a range of 100 nm to 1,500 nm, and more preferably in a range of 200 nm to 1,200 nm. In a case that the average pitch of the concavities and convexities is less than the lower limit, the pitch is too small relative to the wavelength of a visible light, and thus any required diffraction of the visible light is less likely to occur in a diffraction grating obtained by use of such a master (master block). In a case that the average pitch exceeds the upper limit, the diffraction angle of the diffraction grating obtained by use of such a master is too small, and thus the functions as the diffraction grating cannot be fulfilled sufficiently. Note that the term "average pitch of the concavities and convexities" means an average value of the pitch of concavities and convexities in a case of measuring the pitch of the concavities and convexities (spacing distance between adjacent convex portions or spacing distance between adjacent concave portions) on a surface of a curable resin layer. Further, such an average value of the pitch of concavities and convexities is obtained as follows. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", or the like), then the distances between randomly selected concave portions or convex portions adjacent to each other are measured at not less than 100 points in the concavity and convexity analysis image, and then the average of the distances is calculated and is determined as the average value of the pitch of concavities and convexities.

Further, the average value of depth distribution of concavities and convexities representing the concave-convex structure 38 is preferably in a range of 20 nm to 200 nm, more preferably in a range of 30 nm to 150 nm. In a case that the average value of depth distribution of the concavities and convexities is less than the lower limit, the height is not sufficient with respect to the wavelength of the visible light, thus resulting in insufficient diffraction; in a case that the average value exceeds the upper limit and that the obtained diffraction grating is used as an optical element on the light extraction port side of an organic EL element, the organic EL element tends to be easily destructed and the life thereof tends to be shortened due to the heat generation occurring when the electric field distribution in the organic layer becomes non-uniform, causing the electric field to concentrate on a certain position or area in the organic layer. The average value (m) of the depth distribution of concavities and convexities is represented by the following formula (I):

[Formula I]

$$ m = \frac{1}{N} \sum_{i=1}^{N} x_i \qquad (\text{I}) $$

[in the formula (I), "N" represents the total number of measurement points (total pixel count), "i" represents any one of integers in a range of 1 to N, "$x_i$" represents data of depth of concavities and convexities at an i-th measurement point, and "m" represents the average value of depth distribution of concavities and convexities].

[Heating step]

It is allowable to perform heating process to the concave-convex structure of the thin film 30 obtained by the above solvent annealing process. Since the wave-like concave-convex structure has been already formed by the solvent annealing process, the heating process blunts the formed concave-convex structure in some case. The heating process, however, is not necessarily indispensable. The heating process is useful, for example, in such a case that any projection portion is formed, due to any reason, at a portion on the surface of the concave-convex structure after the solvent annealing process and/or such a case that the heating process is needed for adjusting the periodicity and/or height of the concave-convex structure. The heating temperature can be, for example, not less than the glass-transition temperatures of the first and second homopolymer segments 32, 34, such as a temperature not less than the glass-transition temperature of each of the first and second homopolymers 32, 34 and not more than a temperature that is higher than the glass-transition temperature by 70 degrees Celsius. The heating process can be performed in the ambient atmosphere by using an oven, etc.

[Seed layer forming step]

As shown in Fig. 1(C), a seed layer 40 functioning as an electroconductive layer for a subsequent electroforming process is formed on the surface of the wave-like structure 38 of the master obtained as described above. The seed layer 40 can be formed by the non-electrolytic plating, sputtering, or vapor deposition. The thickness of the seed layer 40 is preferably not less than 10 nm, and more preferably not less than 20 nm to uniformize the current density during the subsequent electroforming process, thereby making the thickness of the metal layer accumulated by the subsequent electroforming process to be constant. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof.

[Electroforming step]

Next, a metal layer 50 is accumulated on the seed layer 40 by the electroforming (electroplating), as shown in Fig. 1(D). The whole thickness of the metal layer 50 including the thickness of the seed layer 40 can be, for example, in a range of 10 $\mu$m to 3,000 $\mu$m. As the material of the metal layer 50 to be accumulated by the electroforming, it is possible to use any of metal species as described above which can be used as the seed layer 40. Nickel is preferable in view of the wear resistance and releasing property as the mold. In this case, nickel is also preferably used for the seed layer 40. The current density during the electroforming may be, for example, in a range of 0.03 A/cm$^2$ to 10 A/cm$^2$

for suppressing bridge to form a uniform metal layer and in view of shortening of electroforming time (duration of electroforming time). Considering the easiness for performing the subsequent processes such as pressing with respect to a resin layer, releasing, and cleaning, the formed metal layer 50 desirably has appropriate hardness and thickness. A diamond like carbon (DLC) processing or a Cr plating processing treatment may be performed on the surface of the metal layer formed by the electroforming in order to improve the hardness of the metal layer. Alternatively, the surface hardness of the metal layer may be improved by further performing the heating process of the metal layer.

[Releasing step]

The metal layer 50 including the seed layer obtained as described above is released (peeled off) from the base member having the concave-convex structure to thereby obtain a mold as a father die. As the releasing method (peeling method), the metal layer 50 may be released physically, or the first and second homopolymer and the remaining block copolymer may be dissolved to be removed by using an organic solvent which dissolves the first and second homopolymer and the remaining block copolymer, such as toluene, tetrahydrofuran (THF), and chloroform.

[Cleaning step]

In a case of releasing the mold from the base member 10 having the wave-like structure 38 as described above, a polymer portion or portions 60 of the polymer remain(s) on the mold in some cases, as shown in Fig. 1(E). In such a case, each of the polymer portions 60 remaining on the mold can be removed by cleaning. As a cleaning method, the wet cleaning or dry cleaning can be used. As the wet cleaning, the remaining polymer portions 60 can be removed by performing the cleaning with an organic solvent such as toluene and tetrahydrofuran, a surfactant, or an alkaline solution. In a case that the organic solvent is used, ultrasonic cleaning may be carried out. Alternatively, the remained polymer portions 60 may be removed by performing electrolytic cleaning. As the dry cleaning, the remaining polymer portions 60 can be removed by ashing using ultraviolet light and/or plasma. The wet cleaning and the dry cleaning may be used in combination. After the cleaning as described above, a rinse process with pure water or purified water may be performed, and then ozone irradiation may be carried out after a drying process. Thus, a mold 70 having a desired concave-convex structure as shown in Fig. 1(F) is obtained.

Next, a method for producing a diffraction grating usable for the organic EL element, etc., by using the obtained mold 70 will be explained with reference to Fig. 2(A) to Fig. 2(E).

[Mold-release treatment step]

In a case that the mold 70 is used to transfer the concave-convex structure of the mold 70 to a resin, a mold-release treatment may be performed for the mold 70 so as to improve the releasability of the mold from the resin. As the mold-release treatment, a manner to decrease the surface energy is commonly used. Although the mold-release treatment is not particularly limited, the mold-release treatment includes, for example, a method in which a concave-convex surface 70a of the mold 70 is coated with a mold-release agent 72 such as a fluorine-based material and a silicone resin-based mold-release agent, as shown in Fig. 2(A), a method in which the surface is subjected to a treatment using a fluorine-based silane coupling agent, a method in which a film of a diamond like carbon is formed on the surface, etc.

[Step for transferring the concave-convex structure of the mold to a concave-convex forming material layer]

By using the obtained mold 70, a substrate (or a master block) having a concave-convex structure transferred thereon is produced by transferring the concave-convex structure (pattern) of the mold to a concave-convex forming material layer which is formed of an organic material such as a resin or an inorganic material such as a sol-gel material. Note that when transferring the concave-convex structure of the mold 70, the shape of the mold 70 may be changed suitably to the transfer. For example, in a case of performing the transfer with a roll, the mold 70 may be wound around the outer circumferential surface of a cylindrical body as a roll-shaped mold (transfer process using the roll-shaped mold will be described in detail later on).

First, an explanation will be given about a case that the concave-convex forming material to which the concave-convex structure is to be transferred is a resin layer. As the method of the transfer process, for example, a supporting substrate 90 is coated with a curable resin to form a resin layer 80, and then the resin layer 80 is cured while the concave-convex structure of the mold 70 is being pressed against the resin layer 80, as shown in Fig. 2(B). Examples of the supporting substrate 90 include a base member made of a transparent inorganic material such as glass; a base member made of a resin such as polyethylene terephthalate (PET), polyethylene naphthalate (PEN), polycarbonate (PC), cycloolefin polymer (COP), polymethyl methacrylate (PMMA) or polystyrene (PS); a stacked base member having a gas barrier layer made of an inorganic substance such as SiN, $SiO_2$, SiC, $SiO_xN_y$, $TiO_2$, or $Al_2O_3$ formed on the surface of a base member made of any one of the above-described resins; and a stacked base member formed by alternately stacking a base member made of any one of the above-described resins and a gas barrier layer made of any one of the above-described inorganic substances. Further, the thickness of the supporting substrate 90 may be within a range of 1 μm to 500 μm. In a case of performing the transfer by using a roll-shaped mold as the mold 70, an elongated (lengthy) sheet-shaped substrate having flexibility is preferably used as the supporting substrate 90, as will be described later on. Note that although the supporting substrate 90 is desirably transparent depending on the usage, the supporting substrate 90 needs not be transparent in a case of using the resin layer 80 having the concave-convex structure transferred thereon is used again as the mold (master block).

Examples of the concave-convex forming material include curable resins including a variety of kinds of UV curable resin such as epoxy resin, acrylic resin, urethane resin, melamine resin, urea resin, polyester resin, phenol resin, and cross-linking type liquid crystal resin. The thickness of the curable resin is preferably in a range of 0.5 μm to 500 μm. In a case that the thickness is less than the lower limit, heights of the concavities and convexities formed on the surface of the cured resin layer are more likely to be insufficient. In a case that the thickness exceeds the upper limit, the effect of volume change of the resin which occurs upon curing is likely to be so large that the formation of the shape of the concavities and convexities tends to be unsatisfactory.

As a method for coating the supporting substrate 90 with the concave-convex forming material, it is possible to adopt various coating methods such as the spin coating method, spray coating method, dip coating method, dropping method, gravure printing method, screen printing method, relief printing method, die coating method, curtain coating method, ink-jet method, and sputtering method. Further, the condition for curing a concave-convex forming material such as the curable resin varies depending on the kind of the resin used. For example, the curing temperature is preferably in a range of the room temperature to 250 degrees Celsius, and the curing time is preferably in a range of 0.5 minutes to 3 hours. Alternatively, a method may be employed in which the curable resin is cured by being irradiated with energy ray such as ultraviolet light or electron beam. In such a case, the amount of the irradiation is preferably in a range of 20 mJ/cm$^2$ to 5 J/cm$^2$.

Subsequently, the mold 70 is detached from the curable rein layer 80 which has been cured. The method for detaching the mold 70 is not limited to a mechanical releasing method, and any known method can be adopted as the detaching method. Note that in a case of using the above-described roll-shaped mold, a releasing roll (peeling roll) can be used in order to promote the release of the mold off from the cured resin layer 80. Then, as shown in Fig. 2(C), it is possible to obtain a resin film structure 100 in which the cured rein layer 80 having the concavities and convexities is formed on the supporting substrate 90. The resin film structure 100 may be used, as it is, as the diffraction grating. Alternatively, it is also possible to use the resin film structure 100 further as a mold to produce a structure constructed of an organic material such as a resin or a structure constructed of an inorganic material such as a sol-gel material, and to use either of the structures as a diffraction grating, as will be described later on.

The mold-producing method according to the present invention can be used not only for producing a diffraction grating provided on the light extraction port side of the organic EL element but also for producing an optical component having a minute or fine pattern usable for various devices. For example, the mold-producing method according to the present invention can be used to produce a wire grid polarizer, an antireflection film, a liquid crystal display, a touch panel or an optical element for providing the light confinement effect in a solar cell by being placed on the photoelectric conversion surface side of the solar cell.

As described above, the resin film structure 100 having a desired pattern can be obtained. In a case that the inverted pattern of the resin film structure 100 is used as the diffraction grating, the resin film structure 100 obtained through the transfer process of the mold as described above is used as the master block; another transparent supporting substrate 92 is coated with a curable resin layer 82 and the curable resin layer 82 is cured while the resin film structure 100 is being pressed against the curable resin layer 82, as shown in Fig. 2(D), similar to a case in which the resin film structure 100 is formed. Subsequently, the resin film structure 100 is released from the curable resin layer 82 which has been cured, and thus a replica 110 as another resin film structure as shown in Fig. 2(E) can be obtained. Further, it is allowable to produce a replica having the inverted pattern of the replica 110 by performing the above transfer step using the replica 110 as a master and/or to form a sub-replica by repeating the above transfer step again using the replica having the inverted pattern as the master block.

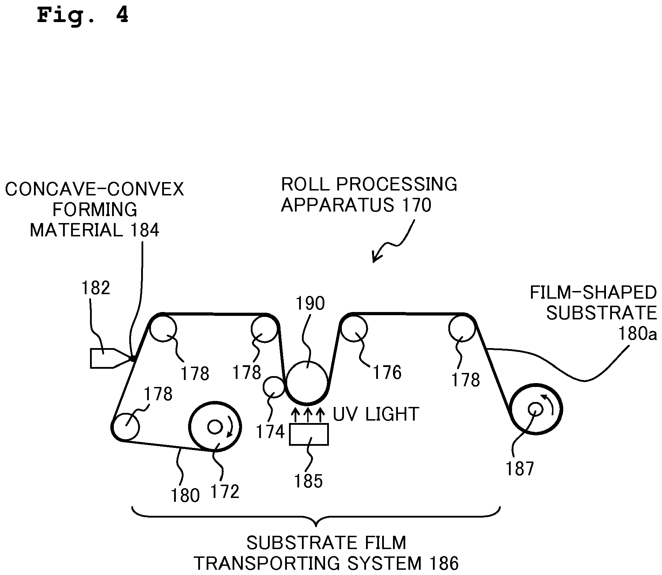

Here, an explanation will be given about a method for effectively performing the transfer process of the mold to the resin layer (roll-to-roll process), with reference to Fig. 4. A roll processing apparatus 170 shown in Fig. 4 forms a concave-convex pattern on a coating film applied (formed) on an elongated (long-length) substrate film 180 to thereby produce a film-shaped substrate 180a. The roll processing apparatus 170 is mainly provided with a transporting system 186 configured to transport the substrate film (base member) 180; a die coater 182 configured to coat the substrate film 180, which is being transported, with a concave-convex forming material; a metallic roll 190 located on the downstream of the die coater 182 and configured to transfer a pattern; and an irradiation light source 185 which is disposed to face the metallic roll 190 with the substrate film 180 being intervened between the irradiation light source 185 and the metallic roll 190, and which is configured to irradiate an UV light onto the substrate film 180. The transporting system 186 for transporting the substrate film 180 has a film feeding roll 172 configured to feed the substrate film 180; a nip roll 174 and a releasing roll 176 arranged respectively on the upstream and the downstream of the metallic roll 190 and configured to urge the substrate film 180 toward the metallic roll 190; a take-up roll (winding roll) 187 configured to take up (wind up) a substrate film 180a having the pattern transferred thereon; and a plurality of transporting rolls 178 configured to transport the substrate film 180. Here, it is possible to use, as the metallic roll 190, a roll-shaped mold obtained by winding the mold 70 (see Fig. 1(F)), which has been prepared in advance, around the outer circumferential surface of a cylindrical body.

The roll processing apparatus 170 is used to obtain a film-shaped substrate having a pattern of the metallic roll 190 transferred thereon, with the following process. The substrate film 180 wound around the film feeding roll 172 in advance is fed toward the downstream by the rotation of the film feeding roll 172, the film take-up roll 187, etc. When the substrate film 180 passes the die coater 182, the die coater 182 coats a surface of the substrate film 180 with a concave-convex forming material 184, thereby forming a coating film having a predetermined thickness. Subsequently, the coating film on the substrate film 180 is pressed against the outer circumferential surface of the metallic roll 190 by the nip roll 174, thereby the pattern on the outer circumferential surface of the metallic roll 190 is transferred to the coating film. Concurrently with or immediately after the pattern transfer, the coating film is irradiated with the UV light from the irradiation light source 185, thereby the concave-convex forming material 184 is cured. Although the wavelength of the UV light is different depending on the kind or property of the concave-convex forming material 184, the wavelength is generally in a range of 200 nm to 450 nm; the irradiation amount of the UV light may be in a range of 10 mJ/cm$^2$ to 5 J/cm$^2$. The substrate film 180 coated with the concave-convex forming material having the cured pattern is released away from the metallic roll 190 by the releasing roll 176, and then is took up (wound up) by the take-up roll 187. In such a manner, the elongated film-shaped substrate 180a can be obtained. The elongated film-shaped substrate 180a can be cut appropriately to be used as diffraction gratings. Alternatively, the elongated film-shaped substrate 180a can be used as a mold to transfer the concave-convex pattern again on a curable resin, a sol-gel material, etc. In particular, it is advantageous to perform the transfer onto the sol-gel material by using the elongated film-shaped substrate 180a as the mold, as will be described later on. Note that such an elongated film-shaped substrate 180a is obtained while being wound in a roll form, and thus is suitable as the mold used in a mass production process of an optical substrate (diffraction grating substrate), and has a suitable form for being transported to an apparatus for mass-producing the optical substrate. Further, after the film-shaped substrate is produced, the film-shaped substrate can be stored or aged while being wound in a rolled form temporarily.

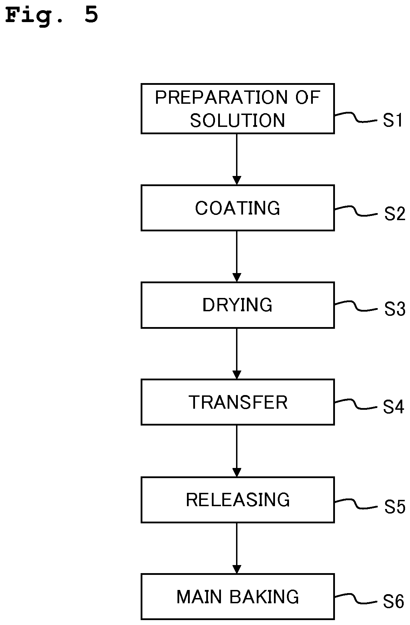

Next, an explanation will be made about a method for producing a structure having concavities and convexities made of a sol-gel material (hereinafter referred to as "sol-gel structure" as appropriate) by further using the obtained resin film structure 100, as shown in Fig. 2(C), as the master block. As shown in Fig. 5, a substrate-forming method for forming a substrate (structure) having a concave-convex pattern using the sol-gel material mainly includes: a solution preparation step S1 for preparing a sol; a coating step (application step) S2 for applying the prepared sol on a substrate (coating the substrate with the sol) to form a coating film; a drying step S3 for drying the coating film with which the substrate is coated; a transferring step S4 for pressing a mold having a transfer pattern formed thereon to the coating film; a releasing step S5 for releasing the mold from the coating film; and a main baking (main calcination) step S6 for subjecting the coating film to main baking. In the following, each of the steps will be explained sequentially.

At first, a sol is prepared to form a coating film, to which a pattern is to be transferred, by the sol-gel method (step S1 in Fig. 5). For example, in a case that silica is synthesized by the sol-gel method on the substrate, a sol of metal alkoxide (silica precursor) is prepared. The silica precursor is exemplified by metal alkoxides including, for example, tetraalkoxide monomers such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, phenyl triisopropoxysilane; a polymer obtained by polymerizing the above monomers in small amounts; and a composite material characterized in that functional group and/or polymer is/are introduced into a part of the material. Further, examples of the silica precursor include metal acetylacetonate, metal carboxylate, oxychloride, chloride, and mixtures thereof. The silica precursor, however, is not limited to these. In addition to Si, the examples of the metal species include Ti, Sn, Al, Zn, Zr, In, and mixtures thereof, but are not limited to these. It is also possible to use any appropriate mixture of precursors of the oxides of the above metals.

In a case that a mixture of TEOS and MTES is used, the mixture ratio thereof can be 1:1, for example, in a molar ratio. This sol produces amorphous silica when caused to perform the hydrolysis and polycondensation reaction. An acid such as hydrochloric acid or an alkali such as ammonia is added in order to adjust the pH of the sol as a synthesis condition. The pH is preferably not more than 4 or not less than 10. Water may be added to perform the hydrolysis. An amount of water to be added can be not less than 1.5 times, with respect to metal alkoxide species, in the molar ratio. As the sol-gel material, it is possible to use a material different from silica, and a material such as a Ti-based material, ITO (indium-tin oxide)-based material, $Al_2O_3$, $ZrO_2$, ZnO, etc., may be used.

Examples of the solvent of the sol include alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-based solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive to the sol, it is possible to use, for example, polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, and dioxane as a solution stabilizer.

The substrate is coated with the sol prepared as described above (step S2 in Fig. 5). From the viewpoint of mass-production, the substrate is preferably coated with the sol at a predetermined position while a plurality of substrates are being transported continuously. As the coating method, it is possible to adopt any coating method such as the bar coating method, spin coating method, spray coating method, dip coating method, die coating method, ink-jet method, etc. Among these methods, the die coating method, bar coating method and spin coating method are preferable because these methods are capable of performing the uniform coating of a substrate, which has a relatively large area, with the sol, and of quickly completing the coating before the sol turns into a gel.

It is allowable to use, as the substrate, substrates made of inorganic materials such as glass, silica glass, and silicon substrates, or substrates made of resins such as polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The substrate may be transparent or opaque, and a relatively hard substrate is preferable considering that a coating film (sol-gel material layer) is formed on the substrate and further a function layer is formed on the sol-gel material layer when the optical substrate is incorporated into a device. Further, in a case that concave-convex patterned substrate obtained by using this substrate is to be used for producing an organic EL element (which will be described later on), this substrate preferably is a substrate having the heat resistance and the weather resistance against the UV light, etc. In view of this, the substrates made of the inorganic materials such as the glass, silica glass and silicon substrates are more preferable. Since the sol-gel material, with which the substrates made of the inorganic materials is to be coated, is made of the inorganic material, the difference in the refractive index between the substrates made of inorganic materials and the sol-gel material layer is small, and thus these substrates are preferable also in view of the capability for preventing any unintended refraction and/or reflection inside the optical substrate. It is allowable to perform a surface treatment for or provide an easy-adhesion layer on the substrate in order to improve the adhesion property, and allowable to provide a gas barrier layer in order to keep out moisture and/or gas such as oxygen. Note that a desired concave-convex pattern is formed with the sol-gel material layer in a subsequent or following step, and thus the surface of the substrate (including the surface treatment or the easy-adhesion layer in case that the surface treatment has been performed or the easy-adhesion layer has been formed) may be flat, and the substrate itself does not have the desired concave-convex pattern. Each of the substrates coated with the sol is transferred (transported) preferably as it is for the subsequent drying and transfer steps.

After the coating step, the substrate is kept (held) in the atmosphere or under reduced pressure to evaporate the solvent in the coating film (hereinafter referred to also as "sol-gel material layer" as appropriate) applied on the substrate (step S3 in Fig. 5) to dry the coating film. In a case that the holding time during which the substrate is kept is short, the viscosity of the coating film is so low that the pattern cannot be transferred in the following transfer step; in a case that the holding time is too long, the polymerization reaction of the precursor is so advanced that the pattern cannot be transferred in the following transfer step. In case of mass-producing the optical substrate, the holding time can be controlled by managing the transporting time during which the substrate is transported from a position where the coating of the substrate with the sol is performed to a position where the substrate is subjected to the following transfer step with the film-shaped substrate (mold). The holding temperature at which the temperature of the substrate is kept in the drying step is preferably a constant temperature in a range of 10 degrees Celsius to 100 degrees Celsius, and more preferably in a range of 10 degrees Celsius to 30 degrees Celsius. In a case that the holding temperature is higher than the upper limit of this range, the gel reaction of the coating film is rapidly proceeds before the transfer step and thus is not desired; in a case that the holding temperature is lower than the lower limit of this range, the gel reaction of the coating film is slowly proceeds before the transfer step, which in turn lowers the productivity and thus not desired. After the sol coating is performed, the polymerization reaction of the precursor proceeds as the evaporation of the solvent proceeds, and the physical property such as the viscosity of the sol changes also in a short period of time. The evaporation amount of the solvent depends also on the amount of solvent (concentration of the sol) used in preparation of the sol. For example, in a case that the sol contains the silica precursor, the hydrolysis and polycondensation reaction of the silica precursor occur as the gel reaction, thereby producing alcohol in the sol via the dealcoholation reaction. On the other hand, a volatile solvent such as alcohol is used in the sol as the solvent. Namely, the sol contains the alcohol produced in the hydrolysis reaction and the alcohol present as the solvent, and the sol-gel reaction proceeds by removing these alcohols in the drying step. Therefore, it is desirable to adjust the holding time and/or holding temperature considering the gel reaction and the solvent used. Note that in the drying step, the solvent in the sol evaporates just by holding the substrate as it is, and thus it is not necessarily indispensable to perform any active drying operation such as heating, air blowing, etc. It is sufficient just to hold the substrate formed with the coating film as it is for a predetermined period of time, to transfer the substrate for a predetermined period of time for the following step(s), etc. From this viewpoint, the drying step may be omitted.

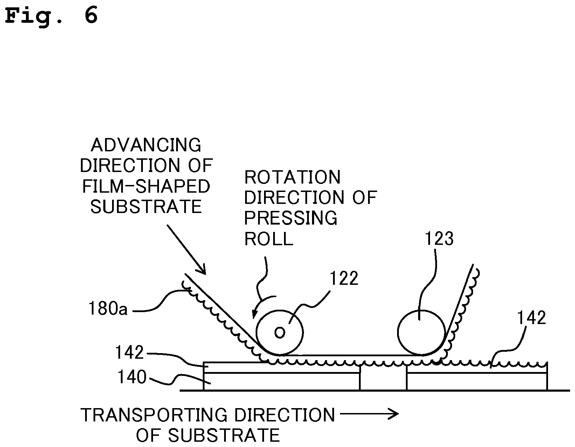

After the predetermined period of time set as described above has elapsed, the film-shaped substrate 180a as the mold obtained in the roll processing apparatus 170 shown in Fig. 4 is pressed against the coating film with a pressing roll (laminating roll) so as to transfer the concave-convex pattern on the film-shaped substrate 180a to the coating film on the substrate (step S4 in Fig. 5). For example, the concave-convex pattern of the film-shaped substrate 180a can be transferred to a coating film (sol) 142 on a substrate 140 by feeding the film-shaped substrate 180a between a pressing roll 122 and the substrate 140 transported immediately below the pressing roll 122, as shown in Fig. 6. Namely, when pressing the film-shaped substrate 180a against the substrate 140 with the pressing roll 122, the film-shaped substrate 180a is made to cover the surface of the coating film 142 of the substrate 140 while the film-shaped substrate 180a and the substrate 140 are being transported in a synchronized manner. At this time, the pressing roll 122 is rotated while being pressed against the back surface of the film-shaped substrate 180a (surface on the opposite side to the other surface of the film-shaped substrate 180a having the concave-convex pattern formed thereon), thereby causing the film-shaped substrate 180a and the substrate 140 to tightly contact with each other while being advanced. Note that for feeding the elongated film-shaped substrate 180a toward the pressing roll 122, it is advantageous to feed out the elongated film-shaped substrate 180a as it is from the take-up roll 187 (see Fig. 4) around which the elongated film-shaped substrate 180a is wound.

By using the elongated film-shaped substrate 180a as the mold, the following advantages are obtained. Namely, with respect to a hard mold that is formed of metal, silica glass, etc., when any defect is found in the concave-convex pattern formed in the hard mold, it is possible to clean a defective portion of the concave-convex pattern at which the defect is located or to repair such defective portion (defect repairing). With this, it is possible to prevent any failure in the substrate 140 which would have been otherwise caused due to the defect transferred to the sol-gel side (the sol-gel material layer on the substrate 140). With respect to a film-shaped mold (soft mold), however, such cleaning and/or repair are not easy to perform therefor. On the other hand, the mold formed of the metal, silica glass, etc. is roll-shaped, and thus when any defect occurs in this mold due to, for example, clogging, etc., the transfer apparatus should be stopped immediately and the mold should be exchanged. In contrast, the transfer with the film-shaped mold is performed while each of the parts of the film-shaped mold being made to correspond to each single glass substrate. Therefore, it is possible to mark any defective portion such as the clogging in the film-shaped mold in advance in an inspection stage, and the transporting operation of the glass substrate can be paused until the defective portion of the film-shaped mold pass the glass substrate. Accordingly, the occurrence of defective product can be lowered as a whole, thereby realizing enhanced throughput. Further, when attempting to transfer the concave-convex pattern from the hard mold made of metal, silica glass, etc., directly to the sol-gel material layer on the substrate, various limitations as described below occur and the desired performance cannot be fully achieved in some cases. For example, in a case of using a hard substrate made of glass, etc. as the substrate on which the sol-gel material layer is formed, the mold and the substrate are both hard. Therefore, when the pressing pressure for the mold is increased, any damage such as cracking or breakage of the substrate occurs; on the contrary, when the pressing pressure for the mold is decreased, the transfer of the concave-convex pattern is shallow, etc., and thus the pressing pressure is hard to adjust. Therefore, there is no choice but to use a soft material for the substrate or to use a soft material for the mold. Even in a case of using a film-shaped mold, a material having a satisfactory releasability is required for the film-shaped mold, and a material having satisfactory adhesiveness with respect to the substrate and satisfactory transfer property for realizing satisfactory transfer of the concave-convex pattern of the film-shaped mold thereto is required as the material to which the concave-convex pattern of the film-shaped mold is transferred. Thus the selectable materials as the material to which the concave-convex pattern of the film-shaped mold is transferred is limited. In view of this, there are provided separate two steps that are a step of firstly preparing (producing) a film-shaped mold from a metallic mold, and another step of using the film-shaped mold to perform the transfer to the sol-gel material layer , while selecting suitable materials for these two steps, respectively, thereby making it possible to use a desired material on a desired substrate in each of these steps, realizing satisfactory transfer not only satisfying the required properties but also generating no defective portions in the pattern and with satisfactory releasability.

Further, the roll process using the pressing roll as described above has the following advantages over the pressing system. Namely, (i) since the period of time during which the mold and the coating film are brought in contact with each other in the roll process is short, it is possible to prevent any deformation of pattern due to the difference in coefficient of thermal expansion among the mold, the substrate, and a stage in which the substrate is placed, etc.; (ii) the productivity is improved owing to the roll process, and the productivity can be further improved by using the elongated film-shaped substrate (film-shaped mold); (iii) it is possible to prevent the generation of bubbles of gas in the pattern due to the bumping of the solvent in the sol or to prevent any trace or mark of gas from remaining; (iv) it is possible to reduce the transfer pressure and releasing force (peeling force) owing to the line contact with the substrate (coating film), thereby making it possible to easily handle a substrate with larger area; and (v) no bubble is included during the pressing. Further, the producing method of the present invention uses the flexible, film-shaped substrate as the mold. Therefore, in a case of transferring the concave-convex pattern of the mold onto the sol-gel material layer formed on a relatively hard substrate, the concave-convex pattern of the mold can be pressed to the sol-gel material layer uniformly across the entire surface of the substrate. With this, the concave-convex pattern of the mold can be transferred faithfully to the sol-gel material layer, thereby making it possible to suppress any occurrence of lack of transfer, or any occurrence of defect, etc.

In this transfer step, the film-shaped substrate may be pressed against the coating film while the coating film is being heated. As the method for heating the coating film, for example, the heating may be performed via the pressing roll, or the coating film may be heated directly or indirectly from the side of the substrate. In a case of performing the heating via the pressing roll, a heating mechanism may be provided inside the pressing roll (transfer roll), and any heating mechanism may be used. Although such a heating mechanism that includes a heater inside the pressing roll is suitable, any separate heater different from the pressing roll may be provided. In either case, any pressing roll may be used, provided that the coating film can be pressed while being heated. The pressing roll is preferably a roll having a heat-resisting coating film, which is provided on a surface thereof and which is made of resin material such as ethylene-propylene-diene rubber (EPDM), silicone rubber, nitrile rubber, fluoro rubber, acrylic rubber, chloroprene rubber, etc. Further, a support roll may be provided to face the pressing roll and to sandwich the substrate between the support roll and the pressing roll, or a support stand configured to support the substrate may be provided, for the purpose of resisting the pressure applied by the pressing roll.

A heating temperature at which the coating film is heated during the transfer can be in a range of 40 degrees Celsius to 150 degrees Celsius. In a case of performing the heating with the pressing roll, the heating temperature of the pressing roll can be similarly in a range of 40 degrees Celsius to 150 degrees Celsius. By heating the pressing roll in such a manner, the mold (film-shaped substrate) can be immediately released from the coating film for which the transfer has been performed with the mold (film-shaped substrate), thereby realizing an increased productivity. In a case that the heating temperature of the coating film or the pressing roll is less than 40 degrees Celsius, the mold cannot be expected to be released quickly from the coating film; in a case that the heating temperature exceeds 150 degrees Celsius, the solvent used evaporate rapidly, which in turn might result in the concave-convex pattern unsatisfactorily transferred. By performing the transfer while heating the coating film, it is possible to expect the effect similar to that obtained by pre-baking of the sol-gel material layer, as described below.

After the film-shaped substrate as the mold is pressed against the coating film (sol-gel material layer), the coating film may be subjected to pre-baking. It is preferred to perform the pre-baking in a case that the transfer is performed without heating the coating film. The pre-baking promotes the gelation of the coating film to solidify the pattern, thereby making the pattern be less likely to be collapsed during the releasing. In a case that the pre-baking is performed, the heating is preferably performed at a temperature in a range of 40 degrees Celsius to 150 degrees Celsius in the atmosphere.

The film-shaped substrate is released from the coating film (sol-gel material layer) after the pressing step or the pre-baking step (step S5 in Fig. 5). Since the roll process is used as described above, the releasing force may be smaller than that in a case of using a plate-shaped mold employed in the pressing system, and it is possible to easily release the mold (film-shaped substrate) from the coating film without leaving the coating film to be remained on the mold (film-shaped substrate). In particular, since the transfer is performed while heating the coating film, the reaction easily proceeds, and the mold can be easily released from the coating film immediately after the transfer. Further, a releasing roll (peeling roll) may be used for enhancing the releasability (peelability) of the mold. As shown in Fig. 6, a peeling roll (releasing roll) 123 is provided on the downstream of the pressing roll 122, and the film-shaped substrate 180a is supported by the rotating peeling roll 123 while being urged by the peeling roll 123 toward the coating film 142. By doing so, it is possible to maintain a state that the film-shaped substrate 180a is adhered to the coating film 142 by a distance from the pressing roll 122 up to the peeling roll 123 (for a predetermined period of time). Further, by changing the course of the film-shaped substrate 180a such that the film-shaped substrate 180a is lifted upward to a position above the peeling roll 123 at the downstream of the peeling roll 123, the film-shaped substrate 180a is peeled off from the coating film 142. Note that the pre-baking and/or the heating of the coating film described above may be performed during a period of time when the film-shaped substrate 180a is adhered to the coating film 142. Further, in a case of using the peeling roll 123, the peeling off of the film-shaped substrate 180a from the coating film can be performed more easily by performing the peeling while the coating film is heated, for example, at a temperature in a range of 40 degrees Celsius to 150 degrees Celsius.

After the film-shaped substrate 180a is peeled off from the coating film (sol-gel material layer) 142 on the substrate 140, the coating film 142 is subjected to the main baking (step S6 in Fig. 5). The hydroxyl group and the like contained in silica, etc. forming the coating film is desorbed or eliminated by the main baking to further strengthen the coating film. The main baking may be performed at a temperature in a range of 200 degrees Celsius to 1200 degrees Celsius for a duration of time about in a range of 5 minutes to 6 hours. In such a manner, the coating film is cured, and a substrate provided with a concave-convex pattern film which corresponds to the concave-convex pattern of the film-shaped substrate 180a is obtained, namely a substrate (diffraction grating) in which the sol-gel material layer having the concave-convex pattern is directly formed on the flat substrate is obtained. In this situation, in a case that the sol-gel material layer is formed of silica, the sol-gel material layer is amorphous, crystalline or in a mixture state of the amorphous and the crystalline, depending on the baking temperature and baking time.

Returning to Fig. 2(E), in a case that the replica 110 (or sol-gel structure) is to be duplicated using the resin film structure 100, or in a case that yet another replica is to be duplicated using the obtained replica 110 (or sol-gel structure), a film may be stacked or deposited, on the surface of the resin film structure 100 or the replica 110 (or sol-gel structure) having the concave-convex pattern formed thereon, by a gas phase method such as the vapor deposition or sputtering method. By stacking the film as described above, in a case that transfer etc. is performed with, for example, coating the surface of the stacked film with the resin, the adhesion between the resin (for example, a UV curable resin) and resin film structure 100 (the replica 110 or the sol-gel structure) can be lowered so as to allow the master block to be peeled off more easily. Examples of the vapor-deposited film include metals such as aluminum, gold, silver, platinum, and nickel; and metal oxides such as aluminum oxide. Further, the thickness of such a vapor-deposited film is preferably in a range of 5 nm to 500 nm. In a case that the thickness is less than the lower limit, a uniform film is difficult to obtain, and thus that the effect of sufficiently lowering the adhesion is decreased. In a case that the thickness exceeds the upper limit, the shape of the master block is more likely to be blunt or dull. In a case that the cured resin layer of the resin film structure 100 or the replica 110 is made of a UV curable resin, postcure may be conducted as appropriate by, for example, performing the irradiation with ultraviolet light again after the resin has been cured.

Furthermore, in the steps shown in Figs. 2(B) and 2(D), the curable resins 80, 82 are applied on the supporting substrates 90, 92, respectively. It is allowable, however, to use a master block obtained by applying the curable resin directly on the surface of the mold 70 which is the original master block or on the surface of the cured resin layer 80, curing the applied curable resin and then detaching the cured curable resin. Alternatively, instead of coating the surface of the master block with the resin, it is allowable to press the master block to a coating film of the resin and to cure the resin so as to obtain a concave-convex film which has concavities and convexities and formed of the cured resin, and to use the obtained concave-convex film of the cured resin as the master block.

[Method for producing organic EL element]

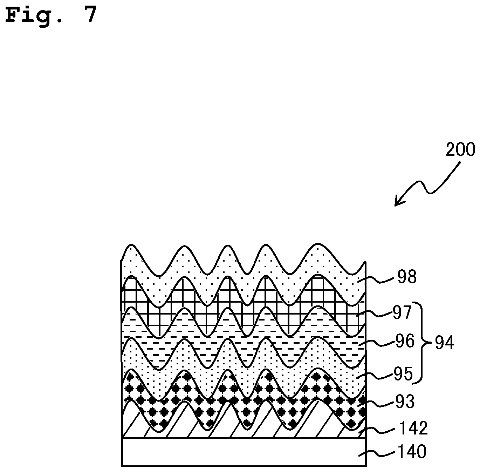

Next, an explanation will be given about a method for producing an organic EL element by using the resin film or the sol-gel structure, which is obtained as described above, as the diffraction grating. Here, although an explanation will be given about a method for producing an organic EL element by using a diffraction grating having a concave-convex pattern formed with a sol-gel material on a surface thereof, in a case of producing the organic EL element by using a diffraction grating formed of the resin film structure 100, a similar process as the method using the diffraction grating having the concave-convex pattern formed of the sol-gel material can be adopted. A substrate 140, on which a pattern made of a sol-gel material layer (coating film) 142 formed via the roll process explained with reference to Fig. 6, is prepared. At first, the substrate 140 is cleaned with a brush, etc., in order to remove any foreign matter adhered to the substrate 140, and an organic matter, etc. is removed with an alkaline cleaning agent and an organic solvent. Next, as shown in Fig. 7, a transparent electrode 93 is stacked on the sol-gel material layer 142 on the substrate 140 so as to maintain the concave-convex structure formed on the surface of the sol-gel material layer (coating film) 142. Examples of those usable as the material for the transparent electrode 93 include indium oxide, zinc oxide, tin oxide, indium-tin oxide (ITO) which is a composite material thereof; gold; platinum, silver; copper, etc. Among these materials, ITO is preferable from the viewpoint of the transparency and the electrical conductivity. The thickness of the transparent electrode 93 is preferably within a range of 20 nm to 500 nm. In a case that the thickness is less than the lower limit, the electrical conductivity is more likely to be insufficient. In a case that the thickness exceeds the upper limit, there is possibility that the transparency is so insufficient that the emitted EL light cannot be extracted to the outside sufficiently. As the method for stacking the transparent electrode 93, it is possible to appropriately use any known method such as the vapor deposition method, sputtering method, spin coating method, etc. Among these methods, the sputtering method is preferably employed from the viewpoint of improving adhesion property. Afterwards, the transparent electrode 93 is coated with photoresist, followed by being exposed with an electrode mask pattern. Then, etching is performed with a developing solution, thereby obtaining a transparent electrode having a predetermined pattern. Note that during the sputtering, the substrate is exposed to a high temperature of about 300 degrees Celsius. After cleaning the obtained transparent electrode with a brush and removing any organic matter, etc., with an alkaline cleaning agent and an organic solvent, an UV ozone treatment is preferably performed.

Next, an organic layer 94 as shown in Fig. 7 is stacked on the transparent electrode 93. The organic layer 94 is not particularly limited, provided that the organic layer 94 is one usable as an organic layer of the organic EL element. As the organic layer 94, any known organic layer can be used as appropriate. Further, the organic layer 94 may be a stacked body of various organic thin films, and may be, for example, a stacked body of a hole transporting layer 95, a light emitting layer 96, and an electron transporting layer 97 as shown in Fig. 7. Here, examples of the material of the hole transporting layer 95 include aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl($\alpha$-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino) triphenylamine (m-MTDATA). The material of the hole transporting layer 95, however, is not limited to these.

Further, the light emitting layer 96 is provided so that a hole injected from the transparent electrode 93 and an electron injected from a metal electrode 98 are recombined to emit light. Examples of the material usable as the light emitting layer 96 include: metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Furthermore, it is preferable that light-emitting materials selected from the above compounds are mixed as appropriate and then are used. Moreover, it is possible to preferably use a material system generating emission of light from a spin multiplet, such as a phosphorescence emitting material generating emission of phosphorescence, and a compound including, in a part of the molecules, a constituent portion formed by the above materials. Note that the phosphorescence emitting material preferably includes heavy metal such as iridium. A host material having high carrier mobility may be doped with each of the light-emitting materials as a guest material to generate the light emission using the dipole-dipole interaction (Forster mechanism) or electron exchange interaction (Dexter mechanism). Examples of the material of the electron transporting layer 97 include heterocyclic tetracarboxylic anhydrides such as nitro-substituted fluorene derivatives, diphenylquinone derivatives, thiopyran dioxide derivatives, and naphthaleneperylene; and metallo-organic complex such as carbodiimide, fluorenylidene methane derivatives, anthraquino dimethane and anthrone derivatives, oxadiazole derivatives, and aluminum-quinolinol complex (Alq3). Further, in the above-described oxadiazole derivatives, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecular chain. Note that the hole transporting layer 95 or the electron transporting layer 97 may also function as the light-emitting layer 96. In this case, the organic layer between the transparent electrode 93 and the metal electrode 98 is double-layered.

From the viewpoint of facilitating the electron injection from the metal electrode 98, a layer made of a metal fluoride or metal oxide such as lithium fluoride (LiF) or $Li_2O_3$, a highly active alkaline earth metal such as Ca, Ba, or Cs, an organic insulating material, or the like may be provided as an electron injection layer between the organic layer 94 and the metal electrode 98. Further, from the viewpoint of facilitating the hole injection from the transparent electrode 93, it is allowable to provide, between the organic layer 94 and the transparent electrode 93, a layer made of triazol derivatives, oxadiazole derivative, imidazole derivative, polyarylalkane derivatives, pyrazoline and pyrazolone derivatives, phenylenediamine derivative, arylamine derivatives, amino-substituted calcone derivatives, oxazole derivatives, styrylanthracene derivatives, fluorenone derivatives, hydrazone derivatives, stilbene derivatives, silazane derivatives, aniline-based copolymers, or electroconductive high-molecular oligomar, particularly thiophene oligomer, as a hole injection layer.

Furthermore, in a case that the organic layer 94 is a stacked body formed of the hole transporting layer 95, the light emitting layer 96 and the electron transporting layer 97, the thicknesses of the hole transporting layer 95, the light emitting layer 96 and the electron transporting layer 97 are preferably within a range of 1 nm to 200 nm, a range of 5 nm to 100 nm, and a range of 5 nm to 200 nm, respectively. As the method for stacking the organic layer 94, any known method such as the vapor deposition method, sputtering method, spin coating method and die coating method can be employed as appropriate.

In the step for forming the organic EL element, subsequently, a metal electrode 98 is stacked on the organic layer 94, as shown in Fig. 7. Materials of the metal electrode 98 are not particularly limited, and a substance having a small work function can be used as appropriate. Examples of the materials include aluminum, MgAg, MgIn, and AlLi. The thickness of the metal electrode 98 is preferably within a range of 50 nm to 500 nm. In a case that the thickness is less than the lower limit, the electrical conductivity is more likely to be decreased. In a case that the thickness exceeds the upper limit, there is possibility that the repair might be difficult to perform when any short circuit occurs between the electrodes. Any known method such as the vapor deposition method, sputtering method, etc. can be adopted to stack the metal electrode 98. Accordingly, an organic EL element 200 having a structure as shown in Fig. 7 can be obtained.

The organic EL element produced by using a diffraction grating formed of the sol-gel material as described above is advantageous in the following points as compared with an organic EL element produced by using a diffraction grating of which concave-convex pattern is formed of a curable resin. Namely, since the sol-gel material has excellent mechanical strength, any flaw or scratch, adhesion of any foreign matter, generation of any projected portion on the transparent electrode during the production process of the organic EL element are less likely to occur even in a case that the cleaning with a brush is performed for the surface formed with the concave-convex pattern after the formation of the substrate and the transparent electrode, thereby making it possible to suppress any failure of the element which would be otherwise caused by the flaw, foreign matter, projected portion, etc. Therefore, the organic EL element obtained by the method of the present invention is more superior to that obtained by using the substrate made of the curable resin, in view of the mechanical strength of the substrate having the concave-convex pattern. Further, the substrate formed of the sol-gel material has excellent chemical resistance, and thus has a relatively high corrosion resistance against the alkaline solution, the organic solvent, etc. used in the cleaning step of the substrate and the transparent electrode, thereby making it possible to use a variety of kinds of cleaning solutions. Further, although the alkaline developing solution is used during the patterning of substrate in some cases as described above, the substrate formed of the sol-gel material has also chemical resistance against such a developing solution. In this respect, the substrate formed of the sol-gel material is advantageous as compared with the substrate formed of the curable resin of which chemical resistance to an alkaline solution is relatively low. Furthermore, the substrate formed of the sol-gel material has excellent heat resistance. Therefore, the substrate formed of the sol-gel material can withstand a high temperature environment of the sputtering step in the process of forming transparent electrode for the organic EL element. Further, the substrate formed of the sol-gel material has UV resistance and weather resistance superior to those of the substrate made of the curable resin, and thus also has the resistance against the UV ozone cleaning treatment performed after the formation of transparent electrode.

In a case that the organic EL element produced by the method of the present invention is used outdoors, any degradation due to the sunlight can be suppressed more than in a case that an organic EL element produced by using the substrate formed of the curable resin is used. Further, in a case that the curable resin as described above is left under a high temperature environment for a long period of time due to the heat generation during the light emission, the curable resin might be degraded to generate any yellowing, any gas, etc., making any long term use of the organic EL element formed with the resin substrate to be difficult. In the contrast, such degradation is suppressed in the organic EL element provided with the substrate made of the sol-gel material.

EXAMPLES

In the following, the present invention will be specifically explained with examples and comparative example. However, the present invention is not limited to the following examples and comparative example.

At first, eleven kinds of block copolymers 1 to 11 manufactured by POLYMER SOURCE, INC. (hereinafter referred to as "BCP-1" to "BCP-11 ", as appropriate) to be used in Examples 1 and 2 were prepared. In each of the block copolymers, polystyrene (hereinafter abbreviated as "PS" as appropriate) was used as the first polymer segment, and polymethyl methacrylate (hereinafter abbreviated as "PMMA" as appropriate) was used as the second polymer segment. TABLE 1 as follows shows, for each of the block copolymers 1 to 11, the number average molecular weight Mn of the block copolymer, the number average molecular weight Mn of the PS segment and the number average molecular weight Mn of the PMMA segment as Mn (BCP), Mn (PS) and Mn(PMMA), respectively. TABLE 1 also shows, for each of the block copolymers 1 to 11, the volume ratio between the PS segment and the PMMA segment (PS:PMMA) and the molecular weight distribution (Mw/Mn) of the block copolymer, and Tg (glass transition temperature) of each of the PS and PMMA segments as well.

In view of the volume ratios between the polymer segments, variations of the Examples mentioned below using the Polymers BCP-7, BCP-8, BCP-9 or BCP-10 are comparative examples and not embodiments of the invention.

The volume ratio between the first polymer segment and second polymer segment (the first polymer segment: the second polymer segment) in each of the block copolymers was calculated on the assumption that the density of polystyrene was 1.05 $g/cm^3$ and the density of polymethyl methacrylate was 1.19 $g/cm^3$. The number average molecular weights (Mn) and the weight average molecular weights (Mw) of polymer segments or polymers were measured by using a gel permeation chromatography (Model No: "GPC-8020" manufactured by TOSOH CORPORATION, in which TSKgel SuperH1000, SuperH2000, SuperH3000, and SuperH4000 were connected in series). The glass transition temperatures (Tg) of the polymer segments were measured by using a differential scanning calorimeter (manufactured by PERKIN-ELMER, INC. under the product name of "DSC7"), while the temperature was raised at a rate of temperature rise of 20 degrees Celsius/min over a temperature range of 0 degrees Celsius to 200 degrees Celsius. The solubility parameters of polystyrene and polymethyl methacrylate were 9.0 and 9.3, respectively (see "Kagaku Binran Ouyou Hen" (Handbook of Chemistry, Applied Chemistry), 2nd edition).

[TABLE 1]

| | Mn x 1000 | | | PS/ PMMA | Mn/Mw | Tg (°C) | |
|---|---|---|---|---|---|---|---|
| | BCP | PS | PMMA | | | PS | PMMA |
| BCP-1 | 1470 | 750 | 720 | 54/46 | 1.21 | 107 | 134 |
| BCP-2 | 559 | 270 | 289 | 51/49 | 1.18 | 110 | 124 |
| BCP-3 | 1010 | 510 | 500 | 54/46 | 1.18 | 107 | 132 |
| BCP-4 | 1160 | 590 | 570 | 54/46 | 1.25 | 106 | 132 |
| BCP-5 | 1600 | 700 | 900 | 47/53 | 1.25 | - | - |
| BCP-6 | 1725 | 868 | 857 | 53/47 | 1.30 | 96 | 110 |
| BCP-7 | 1120 | 700 | 420 | 65/35 | 1.18 | 107 | 120 |
| BCP-8 | 1350 | 1200 | 150 | 90/10 | 1.30 | - | - |
| BCP-9 | 1756 | 556 | 1200 | 34/66 | 1.29 | - | - |
| BCP-10 | 995 | 315 | 680 | 34/66 | 1.20 | - | - |
| BCP-11 | 263 | 133 | 130 | 54/46 | 1.15 | 110 | 124 |

[Example 1]

Toluene was added to 150 mg of the block copolymer 1 and 37.5 mg of Polyethylene Glycol 2050 manufactured by ALDRICH (average Mn = 2050) as polyethylene oxide so that the total amount thereof was 15 g, followed by dissolution. The physical property of the block copolymer 1 (hereinafter abbreviated as "BCP-1" as appropriate) is shown in TABLE 1.

Then, the solution of the block copolymer was filtered through a membrane filter having a pore diameter of 0.5 $\mu$m to obtain a block copolymer solution. A glass substrate was coated with a mixed solution containing 1 g of KBM-5103 manufactured by SHIN-ETSU SILICONE (SHIN-ETSU CHEMICAL, CO., LTD.), 1 g of ion-exchanged water, 0.1 ml of acetic acid and 19 g of isopropyl alcohol, by the spin coating (which was performed for 10 seconds with rotation speed of 500 rpm, and then performed for 45 seconds with rotation speed of 800 rpm). Then, the heating was performed for 15 minutes at 130 degrees Celsius, and thus a silane-coupling treated glass was obtained. The silane-coupling treated glass as the base member was coated with the obtained block copolymer solution by the spin coat with a film thickness in a range of 150 nm to 170 nm. The spin coat was performed for 10 seconds with a rotation speed of 200 rpm and then was performed for 30 seconds at a rotation speed of 300 rpm.

Then, the base member on which the thin film was formed was stationarily placed in a desiccator, filled in advance with chloroform vapor, at a room temperature for 24 hours to thereby apply the solvent annealing process for the base member. Inside the desiccator (volume: 5 L), a screw-type container charged with 100 g of chloroform was placed, and the atmosphere inside the desiccator was filled with chloroform at the saturated vapor pressure. Concavities and convexities were observed on the surface of the thin film after the solvent annealing process, and it was found that the block copolymer composing the thin film underwent the micro phase separation. The cross section of the thin film was observed by a transmission electron microscope (TEM; model name: H-7100FA manufactured by HITACHI, LTD.). Fig. 8A shows a photograph of the observed cross section of the thin film and Fig. 8B shows an enlarged image of the photograph of Fig. 8A. Since a portion of PS (PS portion) was dyed with Ru04 in advance, the PS portion was photographed to be dark (dark gray) and a portion of PMMA (PMMA portion) was photographed to be light (light gray), as shown in Fig. 8B. From the photos of the observed cross section, the cross section of the PS portion, which is circular, was aligned in two tiers (stages or rows) in a direction perpendicular to the surface of the substrate (height direction) while the circular cross sections of the PS portion are separated from each other in a direction parallel to the surface of the substrate. When considering together with an analysis image obtained by an atomic force microscope (to be described later on), it is appreciated that the PS portion is phase-separated from the PMMA portion so as to generate a horizontal cylinder structure. This is a state in which the PS portion as the core (island) is surrounded by the PMMA portion (sea). Although the reason for this phenomenon is not clear, it is considered as follows. Namely, chloroform as the solvent is a good solvent to both of PS and PMMA, but is better solvent to the PMMA. Therefore, the portion of PMMA swelled to a greater extent than the portion of PS, and thus resulted in the formation of phase separation structure in which a block copolymer has the volume ratio deviating from 5:5. Further, it is also apparent that the surface of the thin film has a wave-like shape reflecting the presence of the PS portion separated with the PMMA portion sandwiched therebetween.

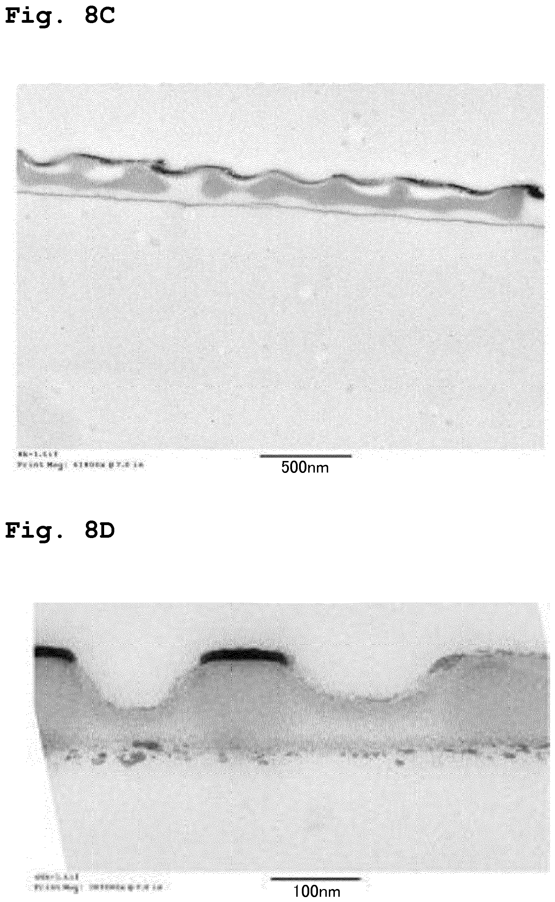

In order to investigate the relationship between the concentration of the block copolymer in the block copolymer solution and the inner structure of the thin film, the concentration of the block copolymer 1 in the block copolymer solution was lowered until the concentration was 0.5%, then a thin film was formed on the substrate in a similar manner as described above, and the solvent annealing process was performed. Fig. 8C shows the structure of the cross section of the thin film observed by the transmission electron microscope, and Fig. 8D is an enlarged image of the cross sectional structure of Fig. 8C. Although the horizontal cylinder structure was maintained, the horizontal cylinder structure was aligned in one tier (row or stage) in the height direction due to the lowered concentration of the block copolymer. Further, also in Fig. 8D, it is also appreciated that the surface of the thin film has a wave-like shape reflecting the presence of the PS portion separated with the PMMA portion sandwiched therebetween. Note that in Figs. 8A to 8D, a portion seen as a deep black portion on the surface of the thin film is a shadow of a protective film coated for the purpose of cutting the thin film, and is not a component of the thin film itself.

About 20 nm of a thin nickel layer was formed as a current seed layer by performing a sputtering on the surface of the thin film processed to have the wave-like shaped by the solvent annealing process. Subsequently, the base member with the thin film was immersed in a nickel sulfamate bath and subjected to an electroforming process (maximum current density: 0.05 A/cm$^2$) at a temperature of 50 degrees Celsius so as to precipitate nickel until the thickness of nickel became 250 $\mu$m. The base member with the thin film was mechanically peeled off or released from the nickel electroforming body obtained in such a manner. Subsequently, polymer component(s) adhered to a part of the surface of the electroforming body was (were) removed by repeating the following process three times. Namely, the nickel electroforming body was immersed in a tetrahydrofuran solvent for 2 hours; then the nickel electroforming body was coated with an acrylic-based UV curable resin; and the acrylic-based UV curable resin, with which the nickel electroforming body is coated, was cured; and then the cured resin was peeled off. After that, the nickel electroforming body was immersed in Chemisol 2303 manufactured by THE JAPAN CEE-BEE CHEMICAL CO., LTD., and was cleaned while being stirred for 2 hours at 50 degrees Celsius. Thereafter, the UV ozone treatment was performed for the nickel electroforming body for 10 minutes.

Subsequently, the nickel electroforming body was immersed in HD-2101TH manufactured by DAIKIN CHEMICAL SALES, CO., LTD. for about 1 minute and was dried, and then stationarily placed overnight. The next day, the nickel electroforming body was immersed in HDTH manufactured by DAIKIN CHEMICAL SALES, CO., LTD. and was subjected to an ultrasonic cleaning process for about 1 minute. In such a manner, a nickel mold for which a mold-release treatment had been performed was obtained.

Subsequently, a PET substrate (COSMOSHINE A-4100 manufactured by TOYOBO CO., LTD.) was coated with a fluorine-based UV curable resin. Then, the fluorine-based UV curable resin was cured by being irradiated with ultraviolet light at 600 mJ/cm$^2$ while the nickel mold was pressed to the PET substrate. After curing of the resin, the nickel mold was peeled off or released from the cured resin. In such a manner, a diffraction grating made of the PET substrate with the resin film to which the surface profile (surface shape) of the nickel mold was transferred was obtained.

An analysis image of the concave-convex shape on the surface of the thin film, which was made to have the wave-like shape by the solvent annealing process (at a stage before the electroforming), was observed by using an atomic force microscope (a scanning probe microscope equipped with an environment control unit "Nanonavi II Station/E-sweep" manufactured by Hitachi High Tech Science Corporation). Analysis conditions of the atomic force microscope were as follows:

Measurement mode: dynamic force mode
Cantilever: SI-DF40P2 (material: Si, lever width: 40 $\mu$m, diameter of tip of chip: 10 nm)
Measurement atmosphere: in air
Measurement temperature: 25 degrees Celsius

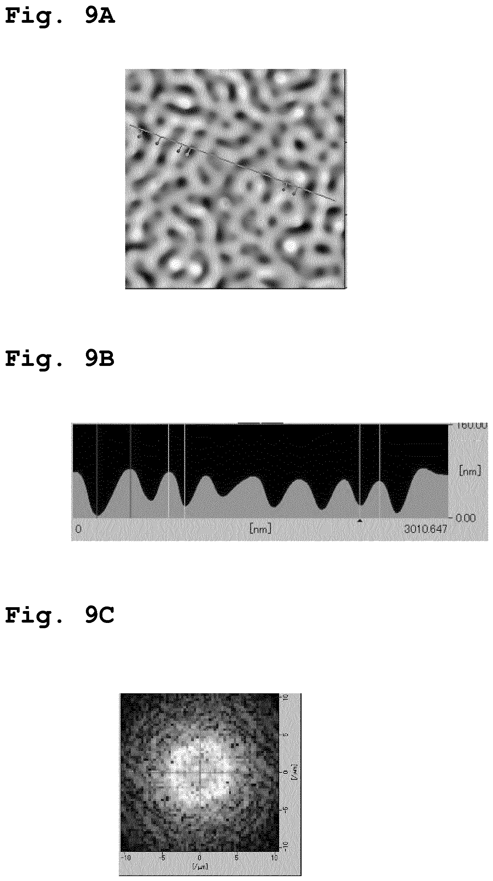

Fig. 9A shows a concavity and convexity analysis image of the surface of the thin film. Further, Fig. 9B shows a concavity and convexity analysis image of the cross section at a portion in the vicinity of the surface of the concave-convex structure of the thin film (showing the cross section along a line in Fig. 9A). From the cross-sectional structure in Fig. 9B, it is appreciated that smooth concavities and convexities are formed on the surface. Note that the full scale of the vertical axis is 160 nm (this is similarly applied to other concavity and convexity analysis image of the cross section). From the concavity and convexity analysis image of the surface of the thin film shown in each of Figs. 9A and 9B, a Fourier transformed image, the average pitch of concavities and convexities, the average value of depth distribution of concavities and convexities, the standard deviation of the depth of concavities and convexities, and the kurtosis of concavities and convexities were obtained in the following manners, respectively.

[Fourier-transformed image]

Concavity and convexity analysis images were obtained in the above-described manner, by performing a measurement in a randomly selected measurement region of 3 $\mu$m square (length: 3 $\mu$m, width: 3 $\mu$m) in the diffraction grating. The obtained concavity and convexity analysis images were subjected to a flattening process including primary inclination correction, and then to two-dimensional fast Fourier transform processing. Thus, a Fourier-transformed image was obtained. Fig. 9C shows the obtained Fourier-transformed image. As is apparent from the result shown in Fig. 9C, it was confirmed that the Fourier-transformed image showed an annular pattern substantially centered at an origin at which an absolute value of wavenumber was 0 $\mu$m$^{-1}$, and that the annular pattern was present within a region where the absolute value of wavenumber was within a range of not more than 10 $\mu$m$^{-1}$.

The circular pattern of the Fourier-transformed image is a pattern observed due to gathering of bright spots in the Fourier-transformed image. The term "circular" herein means that the pattern of the gathering of the bright spots looks like a substantially circular shape, and is a concept further including a case where a part of the contour looks like a convex shape or a concave shape. The pattern formed by the gathering of bright spots may look like a substantially annular shape in some cases, and such cases are expressed with the term "annular". It is noted that the term "annular" is a concept further including a case where a shape of an outer circle or inner circle of the ring looks like a substantially circular shape and further including a case where a part of the contours of the outer circle and/or the inner circle of the ring looks like a convex shape or a concave shape. Further, the phrase "the circular or annular pattern is present within a region where an absolute value of wavenumber is within a range of not more than 10 $\mu$m$^{-1}$ (more preferably in a range of 1.25 $\mu$m$^{-1}$ to 10 $\mu$m$^{-1}$, further preferably from in a range of 1.25 $\mu$m$^{-1}$ to 5 $\mu$m$^{-1}$)" means that not less than 30% (more preferably not less than 50%, further more preferably not less than 80%, and particularly preferably not less than 90%) of the bright spots forming the Fourier-transformed image are present within a region where the absolute value of wavenumber is within a range of not more than 10 $\mu$m$^{-1}$ (more preferably in a range of 1.25 $\mu$m$^{-1}$ to 10 $\mu$m$^{-1}$, and further preferably in a range of 1.25 $\mu$m$^{-1}$ to 5 $\mu$m$^{-1}$).

The two-dimensional fast Fourier transform processing on the concavity and convexity analysis image can be easily performed by electronic image processing using a computer equipped with software for two-dimensional fast Fourier transform processing.

[Average pitch of concavities and convexities]

A concavity and convexity analysis image was obtained in the manner described above by performing a measurement in a randomly selected measurement region of 3 $\mu$m square (length: 3 $\mu$m, width: 3 $\mu$m) in the diffraction grating. Spacing distances between randomly selected concave or convex portions which were adjacent to each other were measured at not less than 100 points in the concavity and convexity analysis image, and the average of the spacing distances was calculated as the average pitch of the concavities and convexities. The average pitch of the concavity and convexity pattern obtained by the analysis image in this example was 73.5 nm.

[Average value of depth distribution of concavities and convexities]

A concavity and convexity analysis image was obtained by performing a measurement in a randomly selected measurement region of 3 $\mu$m square (length: 3 $\mu$m, width: 3 $\mu$m) in the thin film. When doing so, data of height of concavities and convexities at not less than 16,384 points (vertical: 128 points x horizontal: 128 points) was obtained within the measurement region, each in nanometer scale. By using the E-sweep in this example, the measurement was performed at 65,536 points (vertical: 256 points x horizontal: 256 points, namely the measurement at a resolution of 256 pixels) in the measurement region of 3 $\mu$m square. With respect to the height of concavities and convexities (nm) measured in such a manner, at first, a measurement point P is determined, among all the measurement points, which is the highest from the surface of the substrate. Then, a plane which includes the measurement point P and which is parallel to the surface of the substrate is determined as a reference plane (horizontal plane), and a depth value from the reference plane (difference obtained by subtracting, from the value of height from the substrate at the measurement point P, the height from the substrate at each of the measurement points) was obtained as the data of depth of concavities and convexities. Note that such a depth data of the concavities and convexities can be obtained by performing automatic calculation with software in the E-sweep, and the value obtained by the automatic calculation in such a manner can be utilized as the data of depth of concavities and convexities. After obtaining the data of depth of concavity and convexity at each of the measurement points in this manner, the average value (m) of the depth distribution of concavities and convexities can be obtained by performing calculation with the expression (I) described above. The average value (m) of the depth distribution of concavities and convexities of the diffraction grating obtained in this example was 20.6 nm.

[Standard deviation of depth of concavities and convexities]

In a similar manner to the method for measuring the average value (m) of the depth distribution of concavities and convexities as described above, the data of depth of concavities and convexities are obtained by performing a measurement at not less than 16,384 measurement points (vertical: 128 points x horizontal: 128 points) in a randomly selected measurement region of 3 μm square. In this example, measurement points of 65,536 points (vertical: 256 points x horizontal: 256 points) were adopted. Then, the average value (m) of the depth distribution of concavities and convexities and the standard deviation (σ) of depth of concavities and convexities are calculated based on the data of the depth of concavities and convexities at each of the measurement points. Note that the average value (m) of the depth distribution of concavities and convexities can be obtained by performing the calculation (I) described above. On the other hand, the standard deviation (σ) of depth of concavities and convexities can be obtained by performing the following calculation (II):

[Formula II]

$$\sigma = \sqrt{\frac{1}{N}\sum_{i=1}^{N}(x_i - m)^2} \qquad (\mathrm{I\,I})$$

[in the formula (II), "N" represents the total number of measurement points (total pixel count), "$x_i$" represents data of depth of concavity and convexity at an i-th measurement point, and "m" represents the average value of depth distribution of concavities and convexities].

The standard deviation (σ) of depth of concavities and convexities of the thin film was 18.2 nm.

[Kurtosis of concavities and convexities]

In a similar manner as described above, the data of depth of concavities and convexities are obtained by performing a measurement in a randomly selected measurement region of 3 μm square at not less than 16,384 measurement points (vertical: 128 points x horizontal: 128 points). In this example, measurement points of 65,536 points (vertical: 256 points x horizontal: 256 points) were adopted. Then, the average value (m) of the depth distribution of concavities and convexities and the standard deviation (σ) of depth of concavities and convexities are calculated based on the data of the depth of concavity and convexity at each of the measurement points in a manner similar to that described above. Based on the average value (m) of the depth distribution of concavities and convexities and the value of the standard deviation (σ) of depth of concavities and convexities which have been obtained in such a manner, the kurtosis (k) can be obtained by performing the following calculation (III):

[Formula III]

$$k = \frac{\frac{1}{N}\sum_{i=1}^{N}(x_i - m)^4}{\sigma^4} - 3 \qquad (\mathrm{I\,I\,I})$$

[in the formula (III), "N" represents the total number of measurement points (total pixel count), "$x_i$" represents data of depth of concavity and convexity at an i-th measurement point, "m" represents the average value of depth distribution of concavities and convexities, and (σ) represents the value of the standard deviation of depth of concavities and convexities].

In the diffraction grating of the present invention, it has been found, through the experiments previously performed by the applicant of the present application (see, for example, WO2011/007878A1 of the applicant of the present application), that the kurtosis of the concavities and convexities formed on the surface of the thin film is preferably not less than -1.2, more preferably in a range of -1.2 to 1.2, further more preferably in a range of -1.2 to 1, and particularly preferably in a range of -1.1 to 0.0. In a case that the kurtosis as described above is less than the lower limit, there is a tendency that when the diffraction grating is used in the organic EL element, the occurrence of leak current is hard to be suppressed sufficiently. On the other hand, in case that the kurtosis exceeds the upper limit, there are hardly any concavities and convexities in the cross-sectional shape of the thin film and only provides a state that projection portions or recessed portions are present only sparsely, which in turn makes it hard to sufficiently improve the light extraction efficiency as the characteristic of the concave-convex structure (hard to obtain any sufficient diffraction effect). In addition, the electric field easily concentrates to the projection portions, and the leak current tends to generate. In a case that the kurtosis (k) is not less than -1.2, there is no extremely pointed portions in the cross-sectional shape of the concave-convex structure, and the concavities and convexities form a smooth wave-like shape regardless of the height and pitch of concavities and convexities of the wave-like shape and regardless of whether the shape of the surface is regular or irregular. In a case that this is used for the production of organic EL element and that an organic layer is vapor-deposited on the surfaces of the concavities and convexities, it is considered that the thickness of a portion of the organic layer can be prevented from becoming extremely thin, and the organic layer can be stacked with a sufficiently uniform thickness. As a result, the distance between the electrodes can be sufficiently uniform, thereby making it possible to sufficiently prevent any concentration of the electric field. Further, it is considered that the gradient of the electric potential distribution in the organic EL element is smooth at an inclined portion of the wave-like shape of the concave-convex structure, and thus the occurrence of leak current can be sufficiently suppressed. The kurtosis of the concavities and convexities of the diffraction grating obtained in Example 1 was -0.67.

[Example 2]

In Example 2, observation was made as to how the concave-convex structure of the thin film after the solvent annealing process changed, by varying the number average molecular weight (Mn) of the block copolymer and the ratio between the PS portion and PMMA portion composing the block copolymer. As the block copolymer, block copolymer 1 (BCP-1) to block copolymers 11 (BCP-11) respectively having the physical properties as shown in TABLE 1 were used, and a silane-coupling treated glass base member was coated with a solution of the block copolymer, followed by being dried and subjected to the solvent annealing process in a similar manner to that in Example 1, but Example 2 was different from Example 1 in that the blending amount of polyethylene oxide was changed to be 30 parts by mass relative to 100 parts by mass of the block copolymer. An analysis image of the concave-convex shape of the surface of the thin film after having been subjected to the solvent annealing process was observed with an atomic force microscope, under a similar analysis condition to that in Example 1. The physical properties of the used block copolymers 1 to 11 (BCP-1 to BCP-11) are as shown in TABLE 1, and the results of observation of the thin films each obtained by using one of the block copolymers are indicated below.

[Block Copolymer 1 (BCP-1)]

Although the block copolymer 1 was similar to that used in Example 1, the block copolymer solution in Example 2 contained polyethylene oxide in a blending amount higher than in Example 1. From a concavity and convexity analysis image (not shown) of the cross section at a portion in the vicinity of the surface of the thin film obtained by the solvent annealing process, it was appreciated that the shape of concavities and convexities was clearer than that of Example 1. This is considered due to the difference in blending amount of polyethylene oxide. The effect of the blending amount of polyethylene oxide on the height of concavities and convexities will be described in detail in Example 5. According to the calculation performed for the surface of the thin film with the E-sweep based on the concavity and convexity analysis image, the average value of the depth distribution of concavities and convexities was 78.1 nm, the average pitch of concavities and convexities was 305 nm, and the standard deviation of the depth of concavities and convexities was 24.7 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.63.

[Block Copolymer 2 (BCP-2)]

Although the number average molecular weight (Mn) of the block copolymer 2 exceeded 500,000, the number average molecular weights (Mn) of the PS portion and PMMA portion composing the block copolymer 2 were 270,000 and 289,000, respectively, which were considerably lower than those in Example 1. Further, a ratio PS:PMMA as the ratio between the PS portion and the PMMA portion was 51:49. From a concavity and convexity analysis image (not shown) of the cross section at a portion in the vicinity of the surface of the thin film obtained by the solvent annealing process, it was appreciated that the height of concavities and convexities was considerably lower than that of Example 1. According to the calculation performed for the surface of the thin film with the E-sweep based on the concavity and convexity analysis image, the average value of the depth distribution of concavities and convexities was 22.5 nm, the average pitch of concavities and convexities was 162 nm, and the standard deviation of the depth of concavities and convexities was 10.1 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -1.01.

[Block Copolymer 3 (BCP-3)]

The number average molecular weight (Mn) of the block copolymer 3 was 1,010,000, wherein the number average molecular weights (Mn) of the PS portion and PMMA portion composing the block copolymer 3 were 510,000 and 500,000, respectively. Further, a ratio PS:PMMA as the ratio between the PS portion and the PMMA portion was 54:46 that was same as the ratio in Example 1. From a concavity and convexity analysis image (not shown) of the cross section at a portion in the vicinity of the surface of the thin film obtained by the solvent annealing process, it was appreciated that the concavities and convexities on the surface were smooth similarly to that in Example 1. According to the calculation performed for the surface of the thin film with the E-sweep based on the concavity and convexity analysis image, the average value of the depth distribution of concavities and convexities was 47.1 nm, the average pitch of concavities and convexities was 258 nm, and the standard deviation of the depth of concavities and convexities was 18.0 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.95.

[Block Copolymer 4 (BCP-4)]

The number average molecular weight (Mn) of the block copolymer 4 was 1,160,000, wherein the number average molecular weights (Mn) of the PS portion and PMMA portion composing the block copolymer 4 were 590,000 and 570,000, respectively. Further, a ratio PS:PMMA as the ratio between the PS portion and the PMMA portion was 54:46 that was same as the ratio in Example 1. From a concavity and convexity analysis image (not shown) of the cross section at a portion in the vicinity of the surface of the thin film obtained by the solvent annealing process, it was appreciated that the concavities and convexities on the surface were generally smooth, although there were some projection at a portion of the concavities and convexities on the surface. According to the calculation performed for the surface of the thin film with the E-sweep based on the concavity and convexity analysis image, the average value of the depth distribution of concavities and convexities was 80.1 nm, the average pitch of concavities and convexities was 278 nm, and the standard deviation of the depth of concavities and convexities was 31.2 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -1.06.

[Block Copolymer 5 (BCP-5)]

The number average molecular weight (Mn) of the block copolymer 5 was 1,600,000, wherein the number average molecular weights (Mn) of the PS portion and PMMA portion composing the block copolymer 5 were 700,000 and 900,000, respectively. Further, a ratio PS:PMMA as the ratio between the PS portion and the PMMA portion was 47:53. From a concavity and convexity analysis image (not shown) of the cross section at a portion in the vicinity of the surface of the thin film obtained by the solvent annealing process, it was appreciated that the concavities and convexities on the surface were smooth. According to the calculation performed for the surface of the thin film with the E-sweep based on the concavity and convexity analysis image, the average value of the depth distribution of concavities and convexities was 53.7 nm, the average pitch of concavities and convexities was 315 nm, and the standard deviation of the depth of concavities and convexities was 18.0 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.33.

[Block Copolymer 6 (BCP-6)]

The number average molecular weight (Mn) of the block copolymer 6 was 1,725,000, wherein the number average molecular weights (Mn) of the PS portion and PMMA portion composing the block copolymer 6 were 868,000 and 857,000, respectively. Further, a ratio PS:PMMA as the ratio between the PS portion and the PMMA portion was 53:47. From a concavity and convexity analysis image (not shown) of the cross section at a portion in the vicinity of the surface of the thin film obtained by the solvent annealing process, it was appreciated that the concavities and convexities on the surface were smooth. According to the calculation performed for the surface of the thin film with the E-sweep based on the concavity and convexity analysis image, the average value of the depth distribution of concavities and convexities was 72.9 nm, the average pitch of concavities and convexities was 356 nm, and the standard deviation of the depth of concavities and convexities was 19.9 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.09.

[Block Copolymer 7 (BCP-7)]

The number average molecular weight (Mn) of the block copolymer 7 was 1,120,000, wherein the number average molecular weights (Mn) of the PS portion and PMMA portion composing the block copolymer 7 were 700,000 and 420,000, respectively. Further, a ratio PS:PMMA as the ratio between the PS portion and the PMMA portion was 65:35. From a concavity and convexity analysis image (not shown) of the cross section at a portion in the vicinity of the surface of the thin film obtained by the solvent annealing process, it was appreciated that the concavities and convexities on the surface hardly appeared. According to the calculation performed for the surface of the thin film with the E-sweep based on the concavity and convexity analysis image, the average value of the depth distribution of concavities and convexities was 5.0 nm, which was extremely low, and the standard deviation of the depth of concavities and convexities was 1.4 nm. The average pitch of concavities and convexities could not be measured. It was confirmed that the Fourier-transformed image showed a circular pattern substantially centered at an origin at which an absolute value of wavenumber was 0 $\mu m^{-1}$, and that the circular pattern was present within a region where an absolute value of wavenumber was within a range of not more than 10 $\mu m^{-1}$. The kurtosis of concavities and convexities was -0.33.

[Block Copolymer 8 (BCP-8)]

The number average molecular weight (Mn) of the block copolymer 8 was 1,350,000, wherein the number average molecular weights (Mn) of the PS portion and PMMA portion composing the block copolymer 8 were 1,200,000 and 150,000, respectively. Further, a ratio PS:PMMA as the ratio between the PS portion and the PMMA portion was 90:10. From a concavity and convexity analysis image (not shown) of the cross section at a portion in the vicinity of the surface of the thin film obtained by the solvent annealing process, it was appreciated that the concavities and convexities slightly appeared on the surface of the thin film. According to the calculation performed for the surface of the thin film with the E-sweep based on the concavity and convexity analysis image, the average value of the depth distribution of concavities and convexities was 36.9 nm, and the standard deviation of the depth of concavities and convexities was 5.6 nm. The average pitch of concavities and convexities could not be measured. It was confirmed that the Fourier-transformed image showed a circular pattern substantially centered at an origin at which an absolute value of wavenumber was 0 $\mu m^{-1}$, and that the circular pattern was present within a region where an absolute value of wavenumber was within a range of not more than 10 $\mu m^{-1}$. The kurtosis of concavities and convexities was 2.29.

[Block Copolymer 9 (BCP-9)]

The number average molecular weight (Mn) of the block copolymer 9 was 1,756,000, wherein the number average molecular weights (Mn) of the PS portion and PMMA portion composing the block copolymer 9 were 556,000 and 1,200,000, respectively. Further, a ratio PS:PMMA as the ratio between the PS portion and the PMMA portion was 34:66. From a concavity and convexity analysis image (not shown) of the cross section at a portion in the vicinity of the surface of the thin film obtained by the solvent annealing process, the concavities and convexities slightly appeared on the surface of the thin film. According to the calculation performed for the surface of the thin film with the E-sweep based on the concavity and convexity analysis image, the average value of the depth distribution of concavities and convexities was 35.7 nm, and the standard deviation of the depth of concavities and convexities was 14.5 nm. The average pitch of concavities and convexities could not be measured. It was confirmed that the Fourier-transformed image showed a circular pattern substantially centered at an origin at which an absolute value of wavenumber was 0 $\mu m^{-1}$, and that the circular pattern was present within a region where an absolute value of wavenumber was within a range of not more than 10 $\mu m^{-1}$. The kurtosis of concavities and convexities was 0.03.

[Block Copolymer 10 (BCP-10)]

The number average molecular weight (Mn) of the block copolymer 10 was 995,000, wherein the number average molecular weights (Mn) of the PS portion and PMMA portion composing the block copolymer 10 were 315,000 and 680,000, respectively. Further, a ratio PS:PMMA that is a ratio between the PS portion and the PMMA portion was 34:66. From a concavity and convexity analysis image (not shown) of the cross section at a portion in the vicinity of the surface of the thin film obtained by the solvent annealing process, the concavities and convexities slightly appeared on the surface of the thin film. According to the calculation performed for the surface of the thin film with the E-sweep based on the concavity and convexity analysis image, the average value of the depth distribution of concavities and convexities was 31.3 nm, and the standard deviation of the depth of concavities and convexities was 8.5 nm. The average pitch of concavities and convexities could not be measured. It was confirmed that the Fourier-transformed image showed a circular pattern substantially centered at an origin at which an absolute value of wavenumber was 0 $\mu$m$^{-1}$, and that the circular pattern was present within a region where an absolute value of wavenumber was within a range of not more than 10 $\mu$m$^{-1}$. The kurtosis of concavities and convexities was -0.13.

[Block Copolymer 11 (BCP-11)]

The number average molecular weight (Mn) of the block copolymer 11 was 263,000, wherein the number average molecular weights (Mn) of the PS portion and PMMA portion composing the block copolymer 11 were 133,000 and 130,000, respectively. Further, a ratio PS:PMMA as the ratio between the PS portion and the PMMA portion was 54:46. From a concavity and convexity analysis image (not shown) of the cross section at a portion in the vicinity of the surface of the thin film obtained by the solvent annealing process, it was appreciated that the concavities and convexities on the surface were small. According to the calculation performed for the surface of the thin film with the E-sweep based on the concavity and convexity analysis image, the average value of the depth distribution of concavities and convexities was 17.7 nm, the average pitch of concavities and convexities was 87 nm, and the standard deviation of the depth of concavities and convexities was 4.8 nm. It was confirmed that the Fourier-transformed image showed an annular pattern substantially centered at an origin at which an absolute value of wavenumber was 0 $\mu$m$^{-1}$, and that the annular pattern was present within a region where an absolute value of wavenumber was within a range of not more than 15 $\mu$m$^{-1}$. The kurtosis of concavities and convexities was 1.4.

According to the concavity and convexity analysis images, the average values of depth distribution of concavities and convexities and the standard deviation values of the depth of concavities and convexities on the surface of the thin film regarding the block copolymers 1 to 11, it is appreciated that when the number average molecular weight of the block copolymer is less than 500,000, the concave-convex surface hardly appears, that the number average molecular weight of the block copolymer is preferably at least not less than 500,000, and is particularly preferably not less than 1,000,000 in view of the height of concavities and convexities. Further, it is appreciated that when a ratio PS:PMMA as the ratio between the PS portion and the PMMA portion is outside the range of 40:60 to 60:40 as in the block copolymers 7 to 10, the height of concavities and convexities becomes low.

[Example 3]

In Example 3, observation was made as to how the concave-convex structure of the thin film changed, by varying the time (time period) during which the solvent annealing process was performed. As the block copolymer, the block copolymer 1 (BCP-1) which was used in Example 1, was used, and a silane-coupling treated glass base member was coated with a solution of the block copolymer, followed by being dried and subjected to the solvent annealing process with chloroform in a similar manner to that in Example 1, but Example 3 was different from Example 1 in that the solvent annealing processing time was changed to be 1 hour, 3 hours, 6 hours, 12 hours, 48 hours and 168 hours. An analysis image of the concave-convex shape of the surface of the thin film after having been subjected to the solvent annealing process was observed with an atomic force microscope for each of the processing time periods, under a similar analysis condition to that in Example 1. TABLE 2 as follows shows the average values of the depth distribution of concavities and convexities (average of concavities and convexities) on the surface of the thin film, the standard deviation values of the depth of concavities and convexities and the kurtosis values of the concavities and convexities which were calculated with the E-sweep based on these analysis images. It was confirmed that the Fourier-transformed image showed an annular pattern substantially centered at an origin at which an absolute value of wavenumber was 0 $\mu$m$^{-1}$, and that the annular pattern was present within a region where an absolute value of wavenumber was within a range of not more than 10 $\mu$m$^{-1}$ with respect to the film formed with each of these processing time periods. Note that the processing time is preferably in a range of 6 hours to 168 hours, in view of the average value of the depth distribution of concavities and convexities.

[TABLE 2]

| Time (h) | 1 | 3 | 6 | 12 | 24 | 48 | 168 |
|---|---|---|---|---|---|---|---|
| Average of concavities and convexities (nm) | 14.8 | 22.2 | 45.9 | 63.2 | 73.5 | 63.2 | 53.6 |

(continued)

| Time (h) | 1 | 3 | 6 | 12 | 24 | 48 | 168 |
|---|---|---|---|---|---|---|---|
| Standard deviation (nm) | 4.4 | 4.6 | 10.3 | 18.1 | 20.6 | 23.8 | 17.5 |
| Kurtosis | -0.13 | 0.76 | 0.12 | -0.47 | -0.67 | -0.81 | -0.14 |

From the results shown in TABLE 2, it is appreciated that as the solvent annealing time with chloroform was longer, the average value of the depth distribution of concavities and convexities and the standard deviation of the depth of concavities and convexities were increased. As the solvent annealing process with chloroform, a time period of about 3 hours was required until clear concavities and convexities appeared. Note that it was observed that polyethylene oxide precipitated when the solvent annealing time period exceeded 240 hours.

[Example 4]

In Example 4, observation was made as to how the concave-convex structure of the thin film changed, by varying the kind of solvent used for the solvent annealing process. A silane-coupling treated glass base member was coated with a solution of the block copolymer (block copolymer BCP-1), followed by being dried and subjected to the solvent annealing process in a similar manner to that in Example 1, but Example 4 was different from Example 1 in that a mixed solvent of carbon bisulfide and acetone (75:25) was used as the solvent, rather than using chloroform. An analysis image of the concave-convex shape of the surface of the thin film after having been subjected to the solvent annealing process was observed with an atomic force microscope, under a similar analysis condition to that in Example 1. According to the calculation performed for the surface of the thin film with the E-sweep based on the concavity and convexity analysis image, the average value of the depth distribution of concavities and convexities was 50.5 nm, and the standard deviation of the depth of concavities and convexities was 20.0 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.27.

Next, similarly as described above, a silane-coupling treated glass base member was coated with a solution of the block copolymer (block copolymer BCP-1), followed by being dried and subjected to the solvent annealing process, except that the mixture ratio of carbon bisulfide and acetone was changed to 50:50 that was used as the solvent instead of using chloroform. According to the calculation performed for the surface of the thin film with the E-sweep based on the concavity and convexity analysis image of the surface of the thin film and the concavity and convexity analysis image of the cross section at a portion in the vicinity of the surface of the thin film, the average value of the depth distribution of concavities and convexities was 23.6 nm, and the standard deviation of the depth of concavities and convexities was 10.3 nm. It is appreciated that as the mixture ratio of acetone was greater, the height of concavities and convexities became lower. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.98.

Next, similarly as described above, a silane-coupling treated glass base member was coated with a solution of the block copolymer (block copolymer BCP-1), followed by being dried and subjected to the solvent annealing process, except that dichloromethane was singly used as the solvent. According to the calculation performed for the surface of the thin film with the E-sweep based on the concavity and convexity analysis image of the surface of the thin film and the concavity and convexity analysis image of the cross section at a portion in the vicinity of the surface of the thin film, the average value of the depth distribution of concavities and convexities was 45.0 nm, and the standard deviation of the depth of concavities and convexities was 15.0 nm. It was confirmed that the Fourier-transformed image showed an annular pattern substantially centered at an origin at which an absolute value of wavenumber was 0 $\mu m^{-1}$, and that the annular pattern was present within a region where an absolute value of wavenumber was within a range of not more than 10 $\mu m^{-1}$. The kurtosis of concavities and convexities was -0.51.

Next, similarly as described above, a silane-coupling treated glass base member was coated with a solution of the block copolymer (block copolymer BCP-1), followed by being dried and subjected to the solvent annealing process, except that toluene was used as the solvent. From the concavity and convexity analysis image (not shown) of the surface of the thin film and the concavity and convexity analysis image (not shown) of the cross section at a portion in the vicinity of the surface of the thin film, the concavities and convexities appeared not to be very clear, and the pitch of concavities and convexities also appeared to be widen. According to the calculation performed for the surface of the thin film with the E-sweep based on the concavity and convexity analysis image, the average value of the depth distribution of concavities and convexities was 33.0 nm, and the standard deviation of the depth of concavities and convexities was 10.3 nm. It was confirmed that the Fourier-transformed image showed a circular pattern substantially centered at an origin at which an absolute value of wavenumber was 0 $\mu$m$^{-1}$, and that the circular pattern was present within a region where an absolute value of wavenumber was within a range of not more than 10 $\mu$m$^{-1}$. The kurtosis of concavities and convexities was -0.17.

Next, similarly as described above, a silane-coupling treated glass base member was coated with a solution of the block copolymer (block copolymer BCP-1), followed by being dried and subjected to the solvent annealing process, except that acetone was singly used as the solvent. According to the calculation performed for the surface of the thin film with the E-sweep based on the concavity and convexity analysis image of the surface of the thin film and the concavity and convexity analysis image of the cross section at a portion in the vicinity of the surface of the thin film, the average value of the depth distribution of concavities and convexities was 52.1 nm, and the standard deviation of the depth of concavities and convexities was 16.3 nm. It was confirmed that the Fourier-transformed image showed an annular pattern substantially centered at an origin at which an absolute value of wavenumber was 0 $\mu$m$^{-1}$, and that the annular pattern was present within a region where an absolute value of wavenumber was within a range of not more than 10 $\mu$m$^{-1}$. The kurtosis of concavities and convexities was -0.6.

From the above results, it is preferable to use the mixed solvent of carbon bisulfide and acetone, and to use dichloromethane or acetone singly, as the solvent used for the solvent annealing process of the block copolymer composed of PS and PMMA.

[Example 5]

In Example 5, observation was made as to how the concave-convex shape after the solvent annealing process changed, by varying the blending amount of polyethylene oxide (PEO) added to the block copolymer solution. A silane-coupling treated glass base member was coated with a solution of the block copolymer (block copolymer BCP-1), followed by being dried and subjected to the solvent annealing process in a manner similar to that in Example 1, but Example 5 was different from Example 1 in that the parts by mass of polyethylene oxide (expressed in %) relative to 100 parts by mass of the block copolymer was changed to be 0%, 5%, 15%, 25%, 30%, 35% and 70%. Analysis images of the concave-convex shape of the surface of the thin film after having been subjected to the solvent annealing process were observed with an atomic force microscope for the respective blending amounts, under a similar analysis condition to that in Example 1. Then, based on these analysis images of concavities and convexities, the average values of the depth distribution of concavities and convexities on the surface of the thin film (and the standard deviation values of the depth of concavities and convexities as well) were calculated with the E-sweep. The results are shown in TABLE 3 as follows, together with the kurtosis.

[TABLE 3]

| Blending amount of PEO (%) | 0 | 5 | 15 | 25 | 30 | 35 | 70 |
|---|---|---|---|---|---|---|---|
| Average of concavities and convexities (nm) | 10.9 | 32.5 | 51.7 | 73.5 | 78.1 | 83.6 | 62.2 |
| Standard deviation (nm) | 3.4 | 11.5 | 13.7 | 20.6 | 24.7 | 29.2 | 20.0 |
| Kurtosis | -0.74 | -0.59 | -0.25 | -0.67 | -0.63 | -0.81 | -0.44 |

It was confirmed that the Fourier-transformed image showed an annular pattern substantially centered at an origin at which an absolute value of wavenumber was 0 $\mu$m$^{-1}$, and that the annular pattern was present within a region where an absolute value of wavenumber was within a range of not more than 10 $\mu$m$^{-1}$ with respect to each of the thin films which were different in the blending amount of PEO. From the results shown in TABLE 3, the concavity and convexity analysis image of the surface of the thin film and the concavity and convexity analysis image of the cross section at a portion in the vicinity of the surface of the thin film, it is appreciated that when polyethylene oxide was not present in the block copolymer solution, the concavities and convexities hardly appeared in the thin film subjected to the solvent annealing process; however, as the blending amount of polyethylene oxide was greater, the height of concavities and convexities of the thin film became greater. Note that in additional experiments, it was observed that when the blending amount of polyethylene oxide exceeded 70% relative to the block copolymer, polyethylene oxide precipitated. From this result, a suitable blending amount of polyethylene oxide relative to the block copolymer is considered in a range of 5% to 70%.

[Example 6]

In Example 6, observation was made as to how the concave-convex shape changed, depending on the presence or absence of heating treatment (heating annealing) after the solvent annealing process and depending on the heating temperature. As the block copolymer, the block copolymer 1 (BCP-1) was used, and a silane-coupling treated glass base member was coated with a solution of the block copolymer, followed by being dried and subjected to the solvent annealing process in a manner similar to that in Example 1, but Example 6 was different from Example 1 in that the blending amount of polyethylene oxide relative to (100 parts by mass of) the block copolymer was changed to be 30% (30 parts by mass). After the solvent annealing process, there were prepared a sample which was not heated, a sample which was heated for 1 hour at 40 degrees Celsius, a sample which was heated for 1 hour at 50 degrees Celsius, and a sample which was heated for 1 hour at 60 degrees Celsius. With respect to each of these samples, analysis images of the concave-convex shape of the surface of the thin film were observed with an atomic force microscope, under a similar analysis condition to that in Example 1. TABLE 4 as follows shows the average values of the depth distribution of concavities and convexities on the surface of the thin film, the standard deviation values of the depth of concavities and convexities and the kurtosis values of the concavities and convexities which were calculated with the E-sweep based on the analysis images taken for the respective samples.

[TABLE 4]

| Heating temperature | No heating | 40 degrees Celsius | 50 degrees Celsius | 60 degrees Celsius |
| --- | --- | --- | --- | --- |
| Heating Time period | - | 1 hour | 1 hour | 1 hour |
| Average of concavities and convexities (nm) | 71.3 | 55.8 | 40.4 | 27.1 |
| Standard deviation (nm) | 24.6 | 20.0 | 17.1 | 11.9 |
| Kurtosis | -0.75 | -0.88 | -0.11 | -0.19 |

In a case that there was no heating process after the solvent annealing process, the average value of depth distribution of concavities and convexities was 71.3 nm, whereas the heating performed at 40 degrees Celsius for one hour resulted in lowering the average value of depth distribution of concavities and convexities to 55.8 nm. Raising the heating temperature up to 50 degrees Celsius resulted in further lowering the average value of depth distribution of concavities and convexities to 40.4 nm. Moreover, raising the heating temperature further up to 60 degrees Celsius resulted in lowering the average value of depth distribution of concavities and convexities further to 27.1 nm. In view of these results, consequently, the heating process after the solvent annealing process works as thermal annealing (thermal blunting) to cause the pattern to be blunt, lowering the height of concavities and convexities. Note that, as appreciated from the result of Example 1, the method of the present invention realizes the sufficient height of concavities and convexities as well as the kurtosis of -0.75 only with the solvent annealing process, thus obtaining a smooth wave-like shape of the concavities and convexities. Accordingly, it is appreciated that the temperature annealing after the patterning (solvent annealing) is basically unnecessary, except for any special case wherein the height of concavities and convexities needs to be adjusted.

[Comparative Example 1]

Similarly to Example 1, toluene was added to 150 mg of the block copolymer 1 and 37.5 mg of Polyethylene Glycol 2050 manufactured by ALDRICH (average Mn = 2050) as the polyethylene oxide so that the total amount thereof was 15 g, followed by being dissolved. Then, the solution of the block copolymer was filtered in a similar manner as in Example 1 so as to obtain a block copolymer solution. A silane-coupling treated glass (base member), which was prepared in a same manner as in Example 1, was coated with the obtained block copolymer solution by the spin coat, under a similar condition as in Example 1.

Then, the base member was heated for 3 hours in an oven at a temperature of 160 degrees Celsius (annealing process). A thin film on the surface of the base member after the heating was formed with concavities and convexities, and it was observed that the block copolymer underwent the micro phase separation.

The heated thin film was subjected to etching in the following manner: the thin film was irradiated with ultraviolet light by using a high-pressure mercury lamp at irradiation intensity of 30 J/cm$^2$, then the thin film was immersed in acetone, followed by being cleaned with an ion-exchanged water and then dried. By this etching process, the PMMA on the substrate (base member) was selectively removed, and thus a thin film having a fine concave-convex pattern formed thereon was obtained.

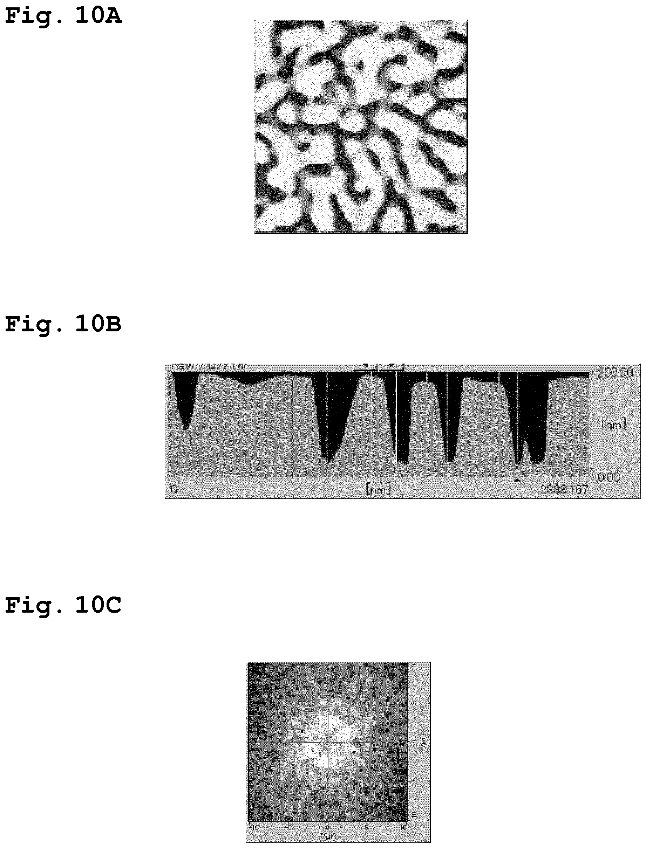

Fig. 10A shows a concavity and convexity analysis image of the surface of the obtained thin film. Fig. 10B shows a concavity and convexity analysis image of the cross section at a portion in the vicinity of the surface of the thin film. In view of the cross-sectional structure shown in Fig. 10B, it is considered that PS and PMMA have the lamella orientation because a vertical cross-sectional structure was present. From the concavity and convexity analysis images each regarding the surface of the thin film shown in Figs. 10A and 10B, a Fourier-transformed image, the average pitch of concavities and convexities, the average value of the depth distribution of concavities and convexities and the standard deviation of depth of concavities and convexities were obtained in a similar manner as in Example 1; the average value of the depth distribution of concavities and convexities was 75.8 nm, the standard deviation of depth of concavities and convexities was 47.2 nm, and the kurtosis was -1.63. It was confirmed that the Fourier-transformed image showed a circular pattern substantially centered at an origin, and that the circular pattern was present within a region where an absolute value of wavenumber was within a range of not more than 10 $\mu m^{-1}$., as shown in Fig. 10C. From these results, it is appreciated that even using the block copolymer having the same composition as that in Example 1, the micro phase separation structure generated by the self-organization of the block copolymer is different due to the difference in the annealing method, and that the horizontal cylinder structure can be generated only by the solvent phase separation (solvent annealing) according to the present invention. Further, it is appreciated that the solvent phase separation according to the present invention can realize a concave-convex structure having a wave-like shape with a smooth surface.

[Example 7]

In Example 7, a mold was produced in accordance with the method of the present invention, a diffraction grating was produced by using the mold, and an organic EL element was produced by using the obtained diffraction grating.

[Production of mold and diffraction grating]

As the block copolymer, block copolymer 1 (BCP-1) was used, and a solution of the block copolymer was prepared and then a silane-coupling treated glass base member was coated with the prepared solution of the block copolymer, followed by being dried and subjected to the solvent annealing process in a manner similar to that in Example 1, but Example 7 was different from Example 1 in that the blending amount of polyethylene oxide was changed to be 30 parts by mass relative to 100 parts by mass of the block copolymer.

By the solvent annealing, concavities and convexities having a wave-like shape was generated on a surface of the thin film. Next, a thin nickel layer having a thickness of about 20 nm was formed on the surface of the thin film as the electric current seed layer by the sputtering. Subsequently, the base member with the thin film was immersed in a nickel sulfamate bath and was subjected to an electro forming process (maximum current density: 0.05 A/cm$^2$) at a temperature of 50 degrees Celsius so as to precipitate nickel until the thickness of nickel became 250 $\mu$m. The base member with the thin film was mechanically peeled off or released from the nickel electroforming body obtained in such a manner. Subsequently, polymer component(s) adhered to a part of the surface of the nickel electroforming body was (were) removed by repeating the following process three times. Namely, the nickel electroforming body was immersed in a tetrahydrofuran solvent for 2 hours; then the nickel electroforming body was coated with an acrylic-based UV curable resin; the acrylic-based UV curable resin, with which the nickel electroforming body was coated, was cured; and then the cured resin was peeled off. After that, the nickel electroforming body was immersed in Chemisol 2303 manufactured by THE JAPAN CEE-BEE CHEMICAL CO., LTD., and cleaned while being stirred for 2 hours at 50 degrees Celsius. Thereafter, the UV ozone treatment was performed for the nickel electroforming body for 10 minutes.

The shape of the concavities and convexities on the surface of the nickel electroforming body was analyzed with the atomic force microscope used in Example 1, and an analysis image was obtained. The analysis image was observed with the atomic force microscope under an analysis condition similar to that in Example 1. According to the calculation performed for the surface of the nickel electroforming body with the E-sweep based on the analysis image, the average height of concavities and convexities (the average value of the depth distribution of concavities and convexities) was 45.7 nm, and the standard deviation of the depth of concavities and convexities was 22.4 nm.

Subsequently, a resin substrate provided with a concave-convex pattern was produced by using the nickel electroforming body as the mold, in the following manner. Namely, a PET substrate (adhesive PET film COSMOSHINE A-4100 manufactured by TOYOBO CO., LTD.) was coated with a fluorine-based UV curable resin. Then, the fluorine-based UV curable resin was cured by irradiation with ultraviolet light at 600 mJ/cm$^2$ while the mold was pressed to the PET substrate. After curing of the resin, the mold was peeled off from the cured resin. Accordingly, a resin substrate with the concave-convex pattern to which the surface profile (surface shape) of the mold was transferred was obtained. The resin substrate with the concave-convex pattern can be used as it is as a diffraction grating. In Example 7, however, this resin substrate with the concave-convex pattern was used again as a mold (diffraction grating-mold) to thereby produce a diffraction grating in the following manner.

2.5 g of tetraethoxysilane (TEOS) and 2.1 g of methyltriethoxysilane (MTES) were added by drops to a mixture solution of 24.3 g of ethanol, 2.16 g of water, and 0.0094 g of concentrated hydrochloric acid, followed by being stirred for 2 hours at a temperature of 23 degrees Celsius and humidity of 45 % to obtain a sol. The sol was applied on a soda-lime glass plate of 15 x 15 x 0.11 cm by a bar coating. Doctor Blade (manufactured by YOSHIMITSU SEIKI CO., LTD.) was used as a bar coater in the bar coating. The doctor blade was designed to form a coating film having a thickness of 5 $\mu$m. However, the doctor blade was adjusted to form the coating film having a thickness of 40 $\mu$m by sticking an imide tape having the thickness of 35 $\mu$m to the doctor blade. When 60 seconds elapsed after the application of the sol, the diffraction grating-mold was pressed against the coating film on the glass plate by a pressing roll using a method described below.

At first, the surface, of the diffraction grating-mold, formed with the pattern was pressed against the coating film on the glass substrate while the pressing roll of which temperature was 23 degrees Celsius was rotated from one end to the other end of the glass substrate. Immediately after the completion of pressing, the substrate was moved on a hot plate and then heated at a temperature of 100 degrees Celsius (pre-baking). After the heating continued for 5 minutes, the substrate was removed from the hot plate and the diffraction grating-mold was manually peeled off from the substrate from the edge such that an angle (peel angle) of the diffraction grating-mold with respect to the substrate was about 30 degrees. Subsequently, main baking was performed by heating the substrate for 60 minutes in an oven at 300 degrees Celsius. Thus, a diffraction grating formed with the concave-convex pattern made of the sol-gel material was obtained.

[Production of organic EL element]

For the glass substrate formed with the pattern made of the sol-gel material thus obtained as the diffraction grating, cleaning was performed with a brush so as to remove any foreign matter, etc., adhered to the glass substrate. After the cleaning, any organic matter, etc., was removed with an alkaline cleaning agent and an organic solvent. On the substrate cleaned in such a manner, ITO was deposited to form an ITO film having a thickness of 120 nm by the sputtering method at 300 degrees Celsius. Then the ITO film was coated with photoresist, and the photoresist was exposed with an electrode mask pattern (mask pattern for electrode), and the etching was performed with an developing solution, thereby obtaining a transparent electrode having a predetermined pattern. The obtained transparent electrode was cleaned with a brush, any organic matter, etc. was removed with an alkaline cleaning agent and an organic solvent, and then the UV ozone treatment was performed for the transparent electrode. On the transparent electrode treated in such a manner, a hole transporting layer (4,4',4"-tris(9-carbazole) triphenylamine; thickness: 35 nm), a light emitting layer (4,4',4"-tris(9-carbazole) triphenylamine doped with tris(2-phenyl pyridinato) iridium (III) complex; thickness: 15 nm, 1,3,5-tris(N-phenylbenzimidazol-2-yl)benzene doped with tris(2-phenyl pyridinato) iridium (III) complex; thickness: 15 nm), an electron transporting layer (1,3,5-tris(N-phenylbenzimidazol-2-yl)benzene; thickness: 65 nm), and a lithium fluoride layer (thickness: 1.5 nm) were stacked by means of the vapor deposition method, and further a metal electrode (aluminum; thickness: 50 nm) was formed thereon by means of the vapor deposition method. Thus, an organic EL element 200 having a coating film (sol-gel material layer) 142, a transparent electrode 93, an organic layer 94 (hole transporting layer 95, light emitting layer 96, and electron transporting layer 97), and a metal electrode 98 provided in this order on a substrate 140 as shown in Fig. 7 was obtained.

[Evaluation of light emission efficiency of organic EL element]

The light emission efficiency of the organic EL element obtained in Example 7 was measured in the following method. Namely, voltage V was applied to the obtained organic EL element, and the applied voltage V and electric current I flowing through the organic EL element were measured with a voltage application current measurement apparatus (manufactured by ADC CORPORATION, model name: R6244) and a total light flux amount L was measured with a total light flux measuring apparatus manufactured by SPECTRA CO-OP. A luminance value L' was calculated from the measured values of the applied voltage V, the electric current I and the total light flux amount L thus obtained, and the electric current efficiency and the electric power efficiency of the organic EL element were calculated by using the following formulae (F1) and (F2), respectively:

$$\text{Electric current efficiency} = (L'/I) \times S \ ... \ (F1);$$

$$\text{Electric power efficiency} = (L'/I/V) \times S \ ... \ (F2),$$

wherein in the above formulae (F1) and (F2), "S" represents a light-emitting area of the organic EL element. Note that, on the assumption that the light distribution characteristics of the organic EL element obeyed the Lambert-Beer law, the total light flux amount L was converted into the luminance value L' in accordance with the following formula (F3):

$$L' = L/\pi/S \ ... \ (F3).$$

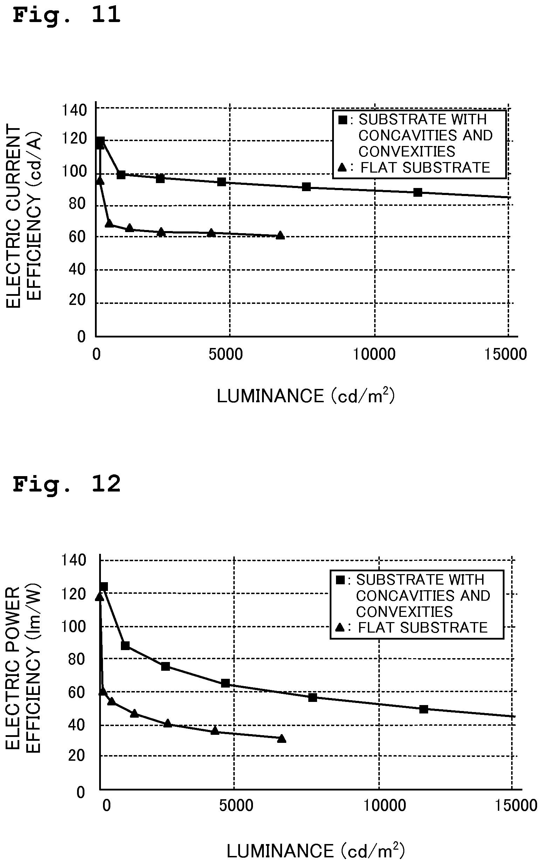

Fig. 11 shows the change in electric current efficiency of the organic EL element with respect to the luminance of the organic EL element. Fig. 12 shows the change in electric power efficiency of the organic EL element with respect to the luminance of the organic EL element. Note that for purpose of comparison, an organic EL element was produced by using a glass substrate not having any concavity and convexity (flat substrate) by a method similar to the method described above, and the electric current efficiency and electric power efficiency of this organic EL element with respect to the luminance of the organic EL element were also indicated in Fig. 11 and Fig. 12, respectively. The organic EL element of Example 7 exhibited the electric current efficiency at the luminance of 1000 cd/m$^2$ that was approximately 1.5 times the electric current efficiency of the organic EL element having no concavity and convexity on the glass substrate. Further, the organic EL element of Example 7 exhibited the electric power efficiency at the luminance of 1000 cd/m$^2$ that was approximately 1.7 times the electric power efficiency of the organic EL element having no concavity and convexity on the glass substrate. Thus, the organic EL element of the present invention had sufficient light extraction efficiency.

[Evaluation of light emission directionality of organic EL element]

The light emission directionality of the organic EL element obtained in Example 7 was evaluated with the following method. Namely, the organic EL element made to emit light was visually observed from all the direction (all-surrounding direction of 360 degrees). There were no particularly bright or dark spots even observing in any direction of all-surrounding 360 degrees, and the organic EL element exhibited uniform brightness in all the direction. Accordingly, the organic EL element of the present invention was confirmed to have a sufficiently low light emission directionality.

As described above, it is appreciated that an organic El element, which is obtained by using a mold and a diffraction grating obtained by using the substrate having the concave-convex pattern formed thereon, which is obtained by the solvent annealing process, have a sufficient light extraction efficiency. Further, since the concave-convex pattern of the diffraction grating produced in Example 7 is formed of the sol-gel material and thus has excellent mechanical strength, chemical resistance and weather resistance, the concave-convex pattern of the diffraction grating is capable of sufficiently withstanding the atmosphere, chemical agent, etc. in each of the steps in the production process for producing the transparent electrode of the organic EL element. For a reason similar to above, an organic EL element as a device produced by the method of the present invention has excellent weather resistance, heat resistance and corrosion resistance, and thus have a long service life.

Although the present invention has been explained as above with the examples, the mold-producing method, diffraction grating-producing method and organic EL element-producing method of the present invention are not limited to the above-described examples, and may be appropriately modified or changed appropriately within the range of the technical ideas described in the following claims.

Further, although the "substrate having a concave-convex pattern" has been explained with an example of a diffraction grating substrate (optical substrate), the "substrate having a concave-convex pattern" is not limited to this; the present invention is applicable to substrates having a variety of applications or usages. The present invention is applicable, for example, to substrates for producing: optical elements such as micro lens arrays, nano prism arrays and optical waveguides; optical parts or components such as lenses; solar cells; anti-reflection films; semiconductor chips; patterned media; data storage; electronic paper; LSI; etc., and to substrates used in applications in the field of the paper production, food production, biotechnology such as immunity analysis chips, cell culture sheets, etc.

INDUSTRIAL APPLICABILITY

According to the present invention, the concave-convex pattern can be formed via the self-organization of the block copolymer by the solvent annealing process, and there is no need to perform the etching. Therefore, the present invention is capable of producing a substrate having the concave-convex pattern exemplified by the diffraction grating, and useful devices such as an organic EL element using such a substrate, etc., with a simple process and high throughput. Thus, the method of the present invention has excellent mass productivity, thereby greatly contributing to the development of the optical device industry in our country.

**Claims**

1. A method for producing a mold for transferring a fine pattern, comprising:

   a step of coating a surface of a base member (10) with a solution containing a block copolymer and polyalkylene oxide, the block copolymer being composed of at least first and second polymer segments;
   a solvent phase-separation step of phase-separating the block copolymer contained in the solution, with which the surface of the base member is coated, under a presence of vapor of an organic solvent so as to obtain a block copolymer film of the block copolymer, the block copolymer film having a concave-convex structure (38) on a surface thereof and a horizontal cylinder structure in an interior thereof;
   a step of forming a seed layer (40) on the concave-convex structure (38) of the block copolymer film;
   a step of stacking a metal layer (50) on the seed layer (40) by electroforming; and
   a step of releasing the base member (10), on which the concave-convex structure (38) is formed, from the metal layer (50), wherein
   a volume ratio between the first and second polymer segments in the block copolymer is in a range of 4:6 to 6:4.

2. The method for producing the mold according to claim 1, wherein a content amount of the polyalkylene oxide is in a range of 5 parts by mass to 70 parts by mass relative to 100 parts by mass of the block copolymer.

3. The method for producing the mold according to any one of claims 1 to 2, wherein number average molecular weight of the block copolymer is not less than 500,000.

4. The method for producing the mold according to any one of claims 1 to 3, wherein no etching process is performed after the solvent phase-separation step.

5. The method for producing the mold according to any one of claims 1 to 4, wherein the first polymer segment composing the block copolymer is polystyrene, and the second polymer segment composing the block copolymer is polymethyl methacrylate.

6. The method for producing the mold according to any one of claims 1 to 5, wherein the organic solvent is one selected from the group consisting of chloroform, acetone, dichloromethane, and a mixed solvent of carbon bisulfide and acetone.

7. The method for producing the mold according to any one of claims 1 to 6, wherein a time for phase-separating the block copolymer under the presence of the vapor of the organic solvent is in a range of 6 hours to 168 hours.

8. The method for producing the mold according to any one of claims 1 to 7, wherein the first or second polymer segment is formed to have a one-tiered structure or a two-tiered structure in the horizontal cylinder structure.

9. The method for producing the mold according to any one of claims 1 to 8, wherein an average value of depth distribution of concavities and convexities of the concave-convex structure is in a range of 30 nm to 150 nm, and standard deviation of depth of the concavities and convexities is in a range of 10 nm to 100 nm.

10. The method for producing the mold according to any one of claims 1 to 9, wherein a primer layer is formed on the surface of the base member before coating the surface of the base member with the solution containing the block copolymer, which is composed of at least the first and second polymer segments, and the polyalkylene oxide.

11. The method for producing the mold according to any one of claims 1 to 10, wherein molecular weight distribution (Mw/Mn) of the block copolymer is not more than 1.5.

12. The method for producing the mold according to any one of claims 1 to 11, wherein difference in solubility parameter between the first and second polymer segments is in a range of 0.1 $(cal/cm^3)^{1/2}$ to 10 $(cal/cm^3)^{1/2}$.

13. A method for producing a substrate having a concave-convex structure, the method comprising:

   providing a mold (70) produced by the method for producing a mold as defined in claim 1;
   pressing the mold (70) onto a substrate coated with a concavity-convexity forming material, curing the concavity-convexity forming material, and removing the mold from the substrate so as to form the substrate having a concave-convex structure.

14. A method for producing a substrate according to claim 13further comprising:

pressing the structure onto another substrate coated with a sol-gel material, curing the sol-gel material, and removing the structure from the another substrate so as to form the another substrate having a concave-convex structure formed of the sol-gel material.

15. A method for producing a diffraction grating according to the method for producing a substrate having a concave-convex structure of claim 13 to form a diffraction grating having a concave-convex structure on the substrate.

16. A method for producing a diffraction grating according to the method for producing a substrate having a concave-convex structure of claim 14 to form a diffraction grating having a concave-convex structure formed of the sol-gel material.

17. A method for producing an organic EL element, the method comprising
providing a diffraction grating produced by the method of producing a diffraction grating as defined in claim 15 or 16;
stacking a transparent electrode (93), an organic layer (94) and a metal electrode (98) successively on a concave-convex structure of the diffraction grating, so as to form the organic EL element.

## Patentansprüche

1. Verfahren zum Herstellen einer Form zum Übertragen einer Feinstruktur, aufweisend:

einen Schritt des Beschichtens einer Oberfläche eines Basiselements (10) mit einer Lösung, die ein Block-Copolymer und Polyalkylenoxid enthält, wobei das Block-Copolymer aus zumindest einem ersten und einem zweiten Polymersegment besteht;
einen Lösungsmittelphasen-Trennschritt der unter Dampf eines organischen Lösungsmittels durchgeführt wird, so dass ein Block-Copolymerfilm des Block-Copolymers erhalten wird, und bei dem eine Phasentrennung des Block-Copolymers, das in der Lösung enthalten ist und mit dem die Oberfläche des Basiselements beschichtet ist, erfolgt, wobei der Block-Copolymerfilm eine konkav-konvexe Struktur (38) auf einer Oberfläche desselben und einen horizontale Zylinderstruktur in einem Inneren desselben aufweist;
einen Schritt des Bildens einer Keimschicht (40) auf der konkav-konvexen Struktur (38) des Block-Copolymerfilms;
einen Schritt des Stapelns einer Metallschicht (50) auf der Keimschicht (40) durch Galvanoformung; und
einen Schritt des Lösens des Basiselements (10), auf dem die konkav-konvexe Struktur (38) ausgebildet ist, von der Metallschicht (50), wobei ein Volumenverhältnis zwischen den ersten und zweiten Polymersegmenten in dem Block-Copolymer in einem Bereich zwischen 4:6 und 6:4 liegt.

2. Verfahren zum Herstellen der Form nach Anspruch 1, wobei ein Mengengehalt des Polyalkylenoxids zwischen 5 Gewichtsteilen und 70 Gewichtsteilen im Verhältnis zu 100 Gewichtsteilen des Block-Copolymers liegt.

3. Verfahren zum Herstellen der Form nach einem der Ansprüche 1 bis 2, wobei das durchschnittliche Molekulargewicht des Block-Copolymers nicht unter 500.000 liegt.

4. Verfahren zum Herstellen der Form nach einem der Ansprüche 1 bis 3, wobei nach dem Lösungsmittelphasen-Trennschritt kein Ätzvorgang durchgeführt wird.

5. Verfahren zum Herstellen der Form nach einem der Ansprüche 1 bis 4, wobei das erste Polymersegment, das das Block-Copolymer bildet, Polystyren ist und das zweite Polymersegment, das das Block-Copolymer bildet, Polymethyl-Methacrylat ist.

6. Verfahren zum Herstellen der Form nach einem der Ansprüche 1 bis 5, wobei das organische Lösungsmittel aus der Gruppe ausgewählt ist, die aus Chloroform, Azeton, Dichlormethan und einem gemischten Lösungsmittel aus Carbon-Bisulfid und Azeton besteht.

7. Verfahren zum Herstellen der Form nach einem der Ansprüche 1 bis 6, wobei eine Zeit für die Phasentrennung des Block-Copolymers bei Vorhandensein des Dampfs des organischen Lösungsmittels in einem Bereich zwischen 6 Stunden und 168 Stunden liegt.

8. Verfahren zum Herstellen der Form nach einem der Ansprüche 1 bis 7, wobei das erste oder zweite Polymersegment ausgebildet ist, um eine einreihige Struktur oder eine zweireihige Struktur in der horizontalen Zylinderstruktur zu haben.

9. Verfahren zum Herstellen der Form nach einem der Ansprüche 1 bis 8, wobei ein Durchschnittswert der Tiefenverteilung der Konkavitäten und Konvexitäten der konkav-konvexen Struktur in einem Bereich zwischen 30 nm und 150 nm liegt, und eine Standardabweichung der Tiefe der Konkavitäten und Konvexitäten in einem Bereich zwischen 10 nm und 100 nm liegt.

10. Verfahren zum Herstellen der Form nach einem der Ansprüche 1 bis 9, wobei eine Grundierungsschicht auf der Oberfläche des Basiselements ausgebildet wird, bevor die Oberfläche des Basiselements mit der Lösung beschichtet wird, die das Block-Copolymer enthält, das aus zumindest dem ersten und dem zweiten Polymersegment und dem Polyalkylenoxid besteht.

11. Verfahren zum Herstellen der Form nach einem der Ansprüche 1 bis 10, wobei die Molekulargewichtsverteilung (Mw/Mn) des Block-Copolymers nicht mehr als 1,5 beträgt.

12. Verfahren zum Herstellen der Form nach einem der Ansprüche 1 bis 11, wobei die Differenz im Löslichkeitsparameter zwischen dem ersten Polymersegment und dem zweiten Polymersegment in einem Bereich zwischen $0,1 \ (cal/cm^3)^{1/2}$ und $10 \ (cal/cm^3)^{1/2}$ liegt.

13. Verfahren zum Herstellen eines Substrats mit einer konkav-konvexen Struktur, wobei das Verfahren aufweist:

   Bereitstellen einer Form (70), die durch das Verfahren zum Herstellen einer Form nach Anspruch 1 hergestellt wurde;
   Pressen der Form (70) auf ein Substrat, das mit einem Konkavitäts-Konvexitäts-Ausbildungsmaterial beschichtet ist, Aushärten des Konkavitäts-Konvexitäts-Ausbildungsmaterial, und Entfernen der Form von dem Substrat, so dass das Substrat mit einer konkav-konvexen Struktur ausgebildet wird.

14. Verfahren zum Herstellen eines Substrats nach Anspruch 13, ferner aufweisend:

   Pressen der Struktur auf ein anderes Substrat, das mit einem Sol-Gel-Material beschichtet ist, Aushärten des Sol-Gel-Materials, und Entfernen der Struktur von dem anderen Substrat, so dass das andere Substrat, das eine konkav-konvexe Struktur aufweist, aus dem Sol-Gel-Material ausgebildet wird.

15. Verfahren zum Herstellen eines Beugungsgitters nach dem Verfahren zum Herstellen eines Substrats mit einer konkav-konvexen Struktur nach Anspruch 13, um ein Beugungsgitter mit einer konkav-konvexen Struktur auf dem Substrat auszubilden.

16. Verfahren zum Herstellen eines Beugungsgitters nach dem Verfahren zum Herstellen eines Substrats mit einer konkav-konvexen Struktur nach Anspruch 14, um ein Beugungsgitter mit einer konkav-konvexen Struktur aus dem Sol-Gel-Material auszubilden.

17. Verfahren zum Herstellen eines organischen EL-Elements, wobei das Verfahren aufweist:

   Bereitstellen eines Beugungsgitters, das durch das Verfahren zum Herstellen eines Beugungsgitters nach Anspruch 15 oder 16 erzeugt wurde;
   Stapeln einer transparenten Elektrode (93), einer organischen Schicht (94) und einer Metallelektrode (98) aufeinander auf einer konkav-konvexen Struktur des Beugungsgitters, um das organische EL-Element auszubilden.

**Revendications**

1. Procédé de production d'un moule pour transférer une structure fine, comprenant :

une étape de revêtement d'une surface d'un élément de base (10) avec une solution contenant un copolymère séquencé et du poly(oxyde d'alkylène), le copolymère séquencé étant composé d'au moins des premier et second segments polymères ;

une étape de séparation de la phase solvant qui consiste à séparer la phase du copolymère séquencé contenu dans la solution dont est revêtue la surface de l'élément de base (10), en présence de vapeur d'un solvant organique de manière à obtenir un film de copolymère séquencé du copolymère séquencé, le film de copolymère séquencé présentant une structure concavo-convexe sur sa surface et une structure cylindrique horizontale à l'intérieur ;

une étape de formation d'une couche germe sur la structure concavo-convexe du film de copolymère séquencé ;

une étape d'empilement d'une couche métallique sur la couche germe par électroformage ; et

une étape de libération de l'élément de base (10) sur lequel est formée la structure concavo-convexe (38), de la couche métallique (50), dans lequel

le rapport volumique entre les premier et second segments polymères du copolymère séquencé se situe dans une plage de 4:6 à 6:4.

2. Procédé de production du moule selon la revendication 1, dans lequel la teneur du poly(oxyde d'alkylène) se situe dans une plage de 5 parties en masse à 70 parties en masse rapportées aux 100 parties en masse du copolymère séquencé.

3. Procédé de production du moule selon l'une quelconque des revendications 1 à 2, dans lequel la masse moléculaire moyenne en nombre du copolymère séquencé n'est pas inférieure à 500 000.

4. Procédé de production du moule selon l'une quelconque des revendications 1 à 3, dans lequel aucune opération de gravure n'est effectuée après l'étape de séparation de la phase solvant.

5. Procédé de production du moule selon l'une quelconque des revendications 1 à 4, dans lequel le premier segment polymère composant le copolymère séquencé est le polystyrène, et le second segment polymère composant le copolymère séquencé est le polyméthacrylate de méthyle.

6. Procédé de production du moule selon l'une quelconque des revendications 1 à 5, dans lequel le solvant organique est un solvant choisi dans le groupe constitué du chloroforme, de l'acétone, du dichlorométhane, et d'un solvant mixte de disulfure de carbone et d'acétone.

7. Procédé de production du moule selon l'une quelconque des revendications 1 à 6, dans lequel la durée de séparation des phases du copolymère séquencé en présence de la vapeur du solvant organique se situe dans une plage de 6 heures à 168 heures.

8. Procédé de production du moule selon l'une quelconque des revendications 1 à 7, dans lequel le premier ou le second segment polymère est formé de manière à présenter une structure à un niveau ou une structure à deux niveaux dans la structure cylindrique horizontale.

9. Procédé de production du moule selon l'une quelconque des revendications 1 à 8, dans lequel la valeur moyenne de distribution de profondeur des concavités et des convexités de la structure concavo-convexe se situe dans une plage de 30 nm à 150 nm, et l'écart-type de profondeur des concavités et des convexités se situe dans une plage de 10 nm à 100 nm.

10. Procédé de production du moule selon l'une quelconque des revendications 1 à 9, dans lequel on forme une couche d'apprêt sur la surface de l'élément de base avant de revêtir la surface de l'élément de base avec la solution contenant le copolymère séquencé, qui est composé au moins des premier et second segments polymères, et le poly(oxyde d'alkylène).

11. Procédé de production du moule selon l'une quelconque des revendications 1 à 10, dans lequel la distribution des masses moléculaires (Mw/Mn) du copolymère séquencé n'est pas supérieure à 1,5.

12. Procédé de production du moule selon l'une quelconque des revendications 1 à 11, dans lequel la différence de paramètre de solubilité entre les premier et second segments polymères se situe dans une plage de 0,1 $(cal/cm^3)^{1/2}$ à 10 $(cal/cm^3)^{1/2}$.

**13.** Procédé de production d'un substrat présentant une structure concavo-convexe, le procédé comprenant :

la fourniture d'un moule (70) produit par le procédé de production de moule selon la revendication 1 ;
le pressage du moule (70) sur un substrat revêtu d'un matériau formant des concavités et des convexités, le durcissement du matériau formant des concavités et des convexités, et le retrait du moule du substrat de manière à former le substrat à structure concavo-convexe.

**14.** Procédé de production d'un substrat selon la revendication 13, comprenant en outre :

le pressage de la structure sur un autre substrat revêtu d'un matériau sol-gel, le durcissement du matériau sol-gel, et le retrait de la structure de l'autre substrat de manière à former ledit autre substrat à structure concavo-convexe formé du matériau sol-gel.

**15.** Procédé de production d'un réseau de diffraction selon le procédé de production d'un substrat présentant une structure concavo-convexe de la revendication 13 pour former un réseau de diffraction présentant une structure concavo-convexe sur le substrat.

**16.** Procédé de production d'un réseau de diffraction selon le procédé de production d'un substrat présentant une structure concavo-convexe de la revendication 14 pour former un réseau de diffraction à structure concavo-convexe formé du matériau sol-gel.

**17.** Procédé de production d'un élément électroluminescent organique, le procédé comprenant :

la fourniture d'un réseau de diffraction produit par le procédé de production d'un réseau de diffraction selon les revendications 15 ou 16 ;
l'empilement d'une électrode transparente (93), d'une couche organique (94) et d'une électrode métallique (98) de manière successive sur la structure concavo-convexe du réseau de diffraction, de manière à former l'élément électroluminescent organique.

# Fig. 1

(A)

(B)

(C)

(D)

(E)

(F)

# Fig. 2

(A)

(B)

(C)

(D)

(E)

# Fig. 3

```
┌─────────────────────────┐
│   PREPARATION OF BLOCK   │
│    COPOLYMER SOLUTION    │
└─────────────────────────┘
             │
             ▼
        ┌──────────┐
        │ COATING  │
        └──────────┘
             │
             ▼
        ┌──────────┐
        │  DRYING  │
        └──────────┘
             │
             ▼
    ┌────────────────────┐
    │  SOLVENT-ANNEALING │
    └────────────────────┘
             │
             ▼
  ┌────────────────────────┐
  │ FORMATION OF SEED LAYER│
  └────────────────────────┘
             │
             ▼
     ┌──────────────────┐
     │  ELECTROFORMING  │
     └──────────────────┘
             │
             ▼
       ┌──────────────┐
       │  RELEASING   │
       └──────────────┘
```

Fig. 4

CONCAVE-CONVEX
FORMING
MATERIAL 184

ROLL PROCESSING
APPARATUS 170

FILM-SHAPED
SUBSTRATE
180a

182

190

178 178

178

176

178

UV LIGHT

174

185

180 172

187

SUBSTRATE FILM
TRANSPORTING SYSTEM 186

Fig. 5

```
┌─────────────────────┐
│   PREPARATION OF     │ ～ S1
│     SOLUTION         │
└─────────────────────┘
          │
          ▼
┌─────────────────────┐
│      COATING         │ ～ S2
└─────────────────────┘
          │
          ▼
┌─────────────────────┐
│      DRYING          │ ～ S3
└─────────────────────┘
          │
          ▼
┌─────────────────────┐
│     TRANSFER         │ ～ S4
└─────────────────────┘
          │
          ▼
┌─────────────────────┐
│     RELEASING        │ ～ S5
└─────────────────────┘
          │
          ▼
┌─────────────────────┐
│    MAIN BAKING       │ ～ S6
└─────────────────────┘
```

# Fig. 6

ADVANCING
DIRECTION OF
FILM-SHAPED
SUBSTRATE

ROTATION
DIRECTION OF
PRESSING
ROLL

123

122

180a

142

142

140

TRANSPORTING DIRECTION ⟶
OF SUBSTRATE

Fig. 7

## Fig. 8A

SURFACE

GLASS
SIDE

500nm

## Fig. 8B

500nm

Fig. 8C

500nm

Fig. 8D

100nm

## Fig. 9A

## Fig. 9B

## Fig. 9C

EP 2 842 721 B1

**Fig. 10A**

**Fig. 10B**

**Fig. 10C**

51

Fig. 11

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010017865 A
- WO 2011007878A1 PCT
- JP 2010056256 A
- WO 2011007878 A1

**Non-patent literature cited in the description**

- Kagaku Binran Ouyou Hen. Handbook of Chemistry, Applied Chemistry